# EUROPEAN PATENT APPLICATION

(11) **EP 4 564 433 A1**
(43) Date of publication of application: **04.06.2025**
(21) Application number: 23846006.7
(22) Date of filing: 01.06.2023
(51) Int. Cl.: H01L 27/146

(54) **SOLID-STATE IMAGING DEVICE AND METHOD FOR MANUFACTURING SAME**

(30) Priority: 26.07.2022 JP 2022119072
(71) Applicant: Sony Semiconductor Solutions Corporation, Atsugi-shi, Kanagawa 243-0014 (JP)
(72) Inventor: YOSHIDA Shinichi, Atsugi-shi, Kanagawa 243-0014 (JP)
(74) Representative: MFG Patentanwälte Meyer-Wildhagen Meggle-Freund Gerhard PartG mbB
(86) International application number: PCT/JP2023/020504
(87) International publication number: WO 2024/024269

(57) **Abstract**

To provide a solid-state imaging device capable of suitably disposing a plug in a substrate, and a manufacturing method of the solid-state imaging device.

A solid-state imaging device of the present disclosure includes a first substrate, a first transistor provided on the first substrate, a first insulating film provided on the first substrate and the first transistor, a first wiring provided in the first insulating film and electrically connected to the first substrate or the first transistor, a second substrate provided on the first insulating film, and a first plug provided in the first insulating film and the second substrate and provided on the first wiring to be electrically connected to the first wiring.

## Description

### TECHNICAL FIELD

The present disclosure relates to a solid-state imaging device and a manufacturing method of the solid-state imaging device.

### BACKGROUND ART

For example, the solid-state imaging device may be manufactured by bonding a first substrate provided with a photodiode, a floating diffusion section, a transfer transistor, and the like and a second substrate different from the first substrate. In this case, when a contact plug (through plug) penetrating the second substrate is disposed in the second substrate, it may be difficult to dispose a pixel transistor on the second substrate. As a result, the degree of freedom in layout of the second substrate may be reduced.

### CITATION LIST

### PATENT DOCUMENT

PATENT DOCUMENT 1: WO 2019/130702 A
PATENT DOCUMENT 2: Japanese Patent Application Laid-Open No. 2019-84191

### SUMMARY OF THE INVENTION

### PROBLEMS TO BE SOLVED BY THE INVENTION

The present disclosure provides a solid-state imaging device in which a plug can be suitably disposed in a substrate, and a manufacturing method of the solid-state imaging device.

### SOLUTIONS TO PROBLEMS

A solid-state imaging device according to a first aspect of the present disclosure includes: a first substrate; a first transistor provided on the first substrate; a first insulating film provided on the first substrate and the first transistor; a first wiring provided in the first insulating film and electrically connected to the first substrate or the first transistor; a second substrate provided on the first insulating film; and a first plug provided in the first insulating film and the second substrate and provided on the first wiring to be electrically connected to the first wiring. As a result, for example, the first plug can be disposed in the second substrate so that the transistor can be easily disposed on the second substrate, and the first plug can be suitably disposed in the second substrate.

Furthermore, the solid-state imaging device according to the first aspect may further include a photoelectric conversion section and a floating diffusion section provided in the first substrate. As a result, for example, the first plug can be suitably disposed in the second substrate bonded to the first substrate on which the photoelectric conversion section and the floating diffusion section are provided.

Furthermore, in the first aspect, the first transistor may include a transfer transistor, an amplification transistor, a switch transistor, or a reset transistor. As a result, for example, the first plug can be suitably disposed in the second substrate bonded to the first substrate on which such a first transistor is provided.

Furthermore, in the first aspect, the first wiring may include a semiconductor layer. As a result, for example, the contact resistance between the first substrate or the first transistor and the first wiring can be reduced.

Furthermore, in the first aspect, the semiconductor layer may include a P-type semiconductor layer or an N-type semiconductor layer. As a result, for example, the contact resistance between the first substrate or the first transistor and the first wiring can be reduced.

Furthermore, in the first aspect, the first plug may include a metal layer. As a result, for example, the first plug with low-resistance can be formed.

Furthermore, the solid-state imaging device of the first aspect may further include a second transistor provided on the second substrate, and a second insulating film provided on the second substrate and the second transistor. As a result, for example, a pixel transistor can be disposed on the second substrate.

Furthermore, in the first aspect, the second transistor may include a selection transistor. As a result, for example, the first plug can be suitably disposed in the second substrate on which the selection transistor is provided.

Furthermore, in the first aspect, the first plug may be provided in the first insulating film, the second substrate, and the second insulating film. As a result, for example, the first plug can be disposed so as to penetrate the second substrate.

Furthermore, in the first aspect, the second transistor may include an amplification transistor, a switch transistor, or a reset transistor. As a result, for example, the first plug can be suitably disposed in the second substrate on which such a second transistor is provided.

Furthermore, in the first aspect, the first plug may be electrically connected to a floating diffusion section provided in the first substrate via the first wiring. As a result, for example, a plug (the first plug) for the floating diffusion section can be suitably disposed.

Furthermore, the solid-state imaging device of the first aspect may further include a second plug provided in the first insulating film and the second substrate and provided on the first substrate to be electrically connected to the first substrate. As a result, for example, the second plug can be dropped directly onto an upper surface of the first substrate.

Furthermore, in the first aspect, the second plug may be provided on a diffusion region provided in the first substrate. As a result, for example, the second plug can be directly dropped on an upper surface of the diffusion region.

Furthermore, in the first aspect, the second plug may include a metal layer. As a result, for example, the second plug with low resistance can be formed.

Furthermore, in the first aspect, the first transistor may be provided on a first surface side of the first substrate, and the solid-state imaging device may further include a lens provided on a second surface side of the first substrate. As a result, for example, in a back-illuminated solid-state imaging device, the first plug can be suitably disposed in the second substrate.

Furthermore, the solid-state imaging device of the first aspect may further include a third substrate provided above the second substrate, a third transistor provided below the third substrate, and a third insulating film provided below the third substrate and the third insulating film and provided on the second insulating film. As a result, for example, a logic circuit including the third transistor can be provided on the third substrate.

A manufacturing method of a solid-state imaging device according to a second aspect of the present disclosure includes: forming a first transistor on a first substrate; forming a first portion of a first insulating film on the first substrate and the first transistor; forming a first wiring on the first portion of the first insulating film to be electrically connected to the first substrate or the first transistor; forming a second portion of the first insulating film on the first portion of the first insulating film and the first wiring; disposing a second substrate on the first insulating film; and forming a first plug provided on the first wiring and electrically connected to the first wiring in the first insulating film and the second substrate. As a result, for example, the first plug can be disposed in the second substrate so that the transistor can be easily disposed on the second substrate, and the first plug can be suitably disposed in the second substrate.

Furthermore, in the second aspect, the first wiring may be formed to include a semiconductor layer. As a result, for example, the contact resistance between the first substrate or the first transistor and the first wiring can be reduced.

Furthermore, the manufacturing method of a solid-state imaging device according to the second aspect may further include implanting a P-type impurity or an N-type impurity into the semiconductor layer. As a result, for example, the contact resistance between the first substrate or the first transistor and the first wiring can be reduced.

Furthermore, in the second aspect, the first plug may be formed to include a metal layer. As a result, for example, the first plug with low-resistance can be formed.

### BRIEF DESCRIPTION OF DRAWINGS

Fig. 1 is a block diagram illustrating a configuration of a solid-state imaging device of a first embodiment.
Fig. 2 is a cross-sectional view illustrating a structure of the solid-state imaging device of the first embodiment.
Fig. 3 is a plan view illustrating the structure of the solid-state imaging device of the first embodiment.
Fig. 4 is a plan view illustrating a structure of a solid-state imaging device according to a comparative example of the first embodiment.
Fig. 5 is another plan view illustrating a structure of the solid-state imaging device of the first embodiment.
Fig. 6 is a circuit diagram illustrating a configuration of the solid-state imaging device of the first embodiment.
Fig. 7 is a cross-sectional view illustrating a structure of a solid-state imaging device of a second embodiment.
Fig. 8 is a cross-sectional view illustrating a structure of a solid-state imaging device according to a third embodiment.
Fig. 9 is a plan view illustrating a structure of the solid-state imaging device according to the third embodiment.
Fig. 10 is a plan view illustrating a structure of a solid-state imaging device according to a comparative example of the third embodiment.
Fig. 11 is a cross-sectional view (1/10) illustrating a manufacturing method of a solid-state imaging device of a fourth embodiment.
Fig. 12 is a cross-sectional view (2/10) illustrating the manufacturing method of the solid-state imaging device of the fourth embodiment.
Fig. 13 is a cross-sectional view (3/10) illustrating the manufacturing method of the solid-state imaging device of the fourth embodiment.
Fig. 14 is a cross-sectional view (4/10) illustrating the manufacturing method of the solid-state imaging device of the fourth embodiment.
Fig. 15 is a cross-sectional view (5/10) illustrating the manufacturing method of the solid-state imaging device of the fourth embodiment.
Fig. 16 is a cross-sectional view (6/10) illustrating the manufacturing method of the solid-state imaging device of the fourth embodiment.
Fig. 17 is a cross-sectional view (7/10) illustrating the manufacturing method of the solid-state imaging device of the fourth embodiment.
Fig. 18 is a cross-sectional view (8/10) illustrating the manufacturing method of the solid-state imaging device of the fourth embodiment.
Fig. 19 is a cross-sectional view (9/10) illustrating the manufacturing method of the solid-state imaging device of the fourth embodiment.
Fig. 20 is a cross-sectional view (10/10) illustrating the manufacturing method of the solid-state imaging device of the fourth embodiment.
Fig. 21 is a circuit diagram illustrating configurations of solid-state imaging devices of fifth and sixth embodiments.
Fig. 22 is a circuit diagram illustrating configurations of solid-state imaging devices of seventh and eighth embodiments.
Fig. 23 is a circuit diagram illustrating a configuration of a solid-state imaging device of a ninth embodiment.
Fig. 24 is a circuit diagram illustrating a configuration of a solid-state imaging device of a tenth embodiment.
Fig. 25 is a circuit diagram illustrating a configuration of a solid-state imaging device of an eleventh embodiment.
Fig. 26 is a circuit diagram illustrating a configuration of a solid-state imaging device of a twelfth embodiment.
Fig. 27 is a circuit diagram illustrating a configuration of a solid-state imaging device of a thirteenth embodiment.
Fig. 28 is a cross-sectional view illustrating a structure of a solid-state imaging device according to a fourteenth embodiment.
Fig. 29 is a block diagram illustrating a configuration example of an electronic device.
Fig. 30 is a block diagram illustrating a configuration example of a moving body control system.
Fig. 31 is a plan view illustrating a specific example of a setting position of an imaging section in Fig. 30.
Fig. 32 is a diagram illustrating an example of a schematic configuration of an endoscopic surgical system.
Fig. 33 is a block diagram illustrating an example of a functional configuration of a camera head and a CCU.

### MODE FOR CARRYING OUT THE INVENTION

Hereinafter, embodiments of the present disclosure will be described with reference to the drawings.

### (First embodiment)

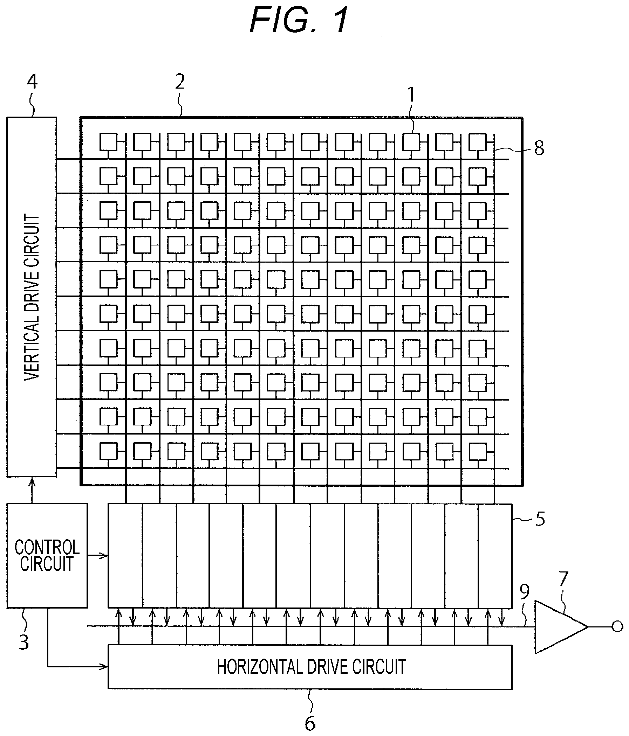

Fig. 1 is a block diagram illustrating a configuration of a solid-state imaging device of a first embodiment.

The solid-state imaging device in Fig. 1 is a complementary metal oxide semiconductor (CMOS) type image sensor (CIS), and includes a pixel array region 2 including a plurality of pixels 1, a control circuit 3, a vertical drive circuit 4, a plurality of column signal processing circuits 5, a horizontal drive circuit 6, an output circuit 7, a plurality of vertical signal lines (VSL) 8, and a horizontal signal line (HSL) 9.

Each of the pixels 1 includes a photodiode functioning as a photoelectric conversion section and a MOS transistor functioning as a pixel transistor. Examples of the pixel transistor include a transfer transistor, a reset transistor, an amplifying transistor, a selection transistor, and a switch transistor. These pixel transistors may be shared by several pixels 1.

The pixel array region 2 includes the plurality of pixels 1 arranged in a two-dimensional array. The pixel array region 2 includes an effective pixel region that receives light, performs photoelectric conversion, and outputs a signal charge generated by the photoelectric conversion, and a black reference pixel region that outputs optical black serving as a reference of a black level. In general, the black reference pixel region is disposed on an outer peripheral portion of the effective pixel region.

The control circuit 3 generates various signals serving as references of operations of the vertical drive circuit 4, the column signal processing circuit 5, the horizontal drive circuit 6, and the like on the basis of a vertical synchronization signal, a horizontal synchronization signal, a master clock, and the like. The signals generated by the control circuit 3 are, for example, a clock signal and a control signal, and are input to the vertical drive circuit 4, the column signal processing circuit 5, the horizontal drive circuit 6, and the like.

The vertical drive circuit 4 includes, for example, a shift register, and scans each of the pixels 1 in the pixel array region 2 in the vertical direction row by row. The vertical drive circuit 4 further supplies a pixel signal based on the signal charge generated by each pixel 1 to the column signal processing circuit 5 through the vertical signal lines 8.

Each of the column signal processing circuits 5 is arranged, for example, for every column of the pixels 1 in the pixel array region 2, and performs signal processing of the signals output from the pixels 1 of one row for every column on the basis of a signal from the black reference pixel region. Examples of this signal processing are noise removal and signal amplification.

The horizontal drive circuit 6 includes, for example, a shift register, and supplies the pixel signal from each of the column signal processing circuits 5 to the horizontal signal line 9.

The output circuit 7 performs signal processing on the signal supplied from each of the column signal processing circuits 5 through the horizontal signal line 9, and outputs the signal subjected to the signal processing.

Note that the pixel array region 2 of the present embodiment may include only one of the pixel 1 that detects visible light and the pixel 1 that detects light other than visible light, or may include both the pixel 1 that detects visible light and the pixel 1 that detects light other than visible light. The light other than the visible light is, for example, infrared light.

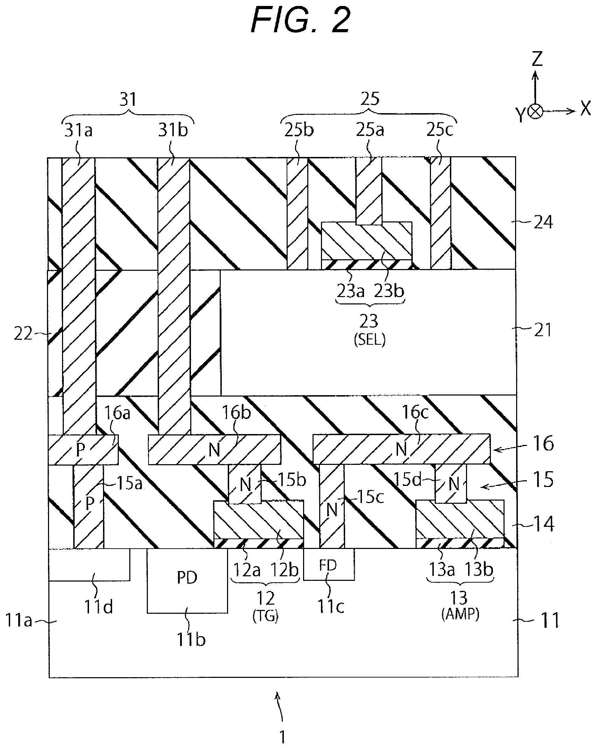

Fig. 2 is a cross-sectional view illustrating a structure of the solid-state imaging device of the first embodiment. Fig. 2 illustrates one pixel 1 in the solid-state imaging device of the present embodiment.

Fig. 2 illustrates an X axis, a Y axis, and a Z axis perpendicular to each other. An X direction and a Y direction correspond to a lateral direction (horizontal direction), and a Z direction corresponds to a longitudinal direction (vertical direction). Furthermore, a +Z direction corresponds to an upward direction, and a -Z direction corresponds to a downward direction. Note that the -Z direction may strictly match the gravity direction, or does not necessarily strictly match the gravity direction.

As illustrated in Fig. 2, the solid-state imaging device of the present embodiment includes a substrate 11, a pixel transistor 12, a pixel transistor 13, an interlayer insulating film 14, a plurality of contact plugs 15, a wiring layer 16, a substrate 21, an insulating film 22, a pixel transistor 23, an interlayer insulating film 24, a plurality of contact plugs 25, and a plurality of through plugs 31. The substrate 11, the pixel transistors 12 and 13, and the interlayer insulating film 14 are examples of a first substrate, a first transistor, and a first insulating film of the present disclosure, respectively. The substrate 21, the pixel transistor 23, and the interlayer insulating film 24 are examples of a second substrate, a second transistor, and a second insulating film of the present disclosure, respectively. Each of the through plugs 31 is an example of a first plug of the present disclosure.

The substrate 11 is, for example, a semiconductor substrate such as a silicon substrate. In Fig. 2, the X direction and the Y direction are parallel to an upper surface of the substrate 11, and the Z direction is perpendicular to the upper surface of the substrate 11. The substrate 11 includes a well region 11a, a diffusion region 11b, a diffusion region 11c, and a diffusion region 11d. Fig. 2 further illustrates a photodiode PD and a floating diffusion section FD formed in the substrate 11. The photodiode PD is formed by a PN junction or the like between the well region 11a and the diffusion region 11b. The diffusion regions 11b and 11c also function as source and drain regions of the pixel transistor 12. The diffusion region 11c also functions as the floating diffusion section FD. The diffusion regions 11b to 11d are also referred to as active regions. The well region 11a, the diffusion region 11b, the diffusion region 11c, and the diffusion region 11d are, for example, P-type, N-type, N-type, and P-type semiconductor regions, respectively.

The pixel transistor 12 includes a gate insulating film 12a and a gate electrode 12b sequentially formed on the substrate 11. The gate insulating film 12a is, for example, a silicon oxide film. The gate electrode 12b is, for example, an N-type semiconductor layer (for example, a polysilicon layer). The gate electrode 12b is disposed between the diffusion region 11b and the diffusion region 11c. The pixel transistor 12 is, for example, a transfer transistor TG.

The pixel transistor 13 includes a gate insulating film 13a and a gate electrode 13b sequentially formed on the substrate 11. The gate insulating film 13a is, for example, a silicon oxide film. The gate electrode 13b is, for example, an N-type semiconductor layer (for example, a polysilicon layer). As illustrated in Fig. 2, the gate electrode 13b is electrically connected to the diffusion region 11c. The pixel transistor 13 is, for example, an amplification transistor AMP.

The interlayer insulating film 14 is formed on the substrate 11 and the pixel transistors 12 and 13, and covers the pixel transistors 12 and 13. The interlayer insulating film 14 is, for example, a multilayer insulating film including a silicon oxide film and another insulating film.

Each of the contact plug 15 is formed in the interlayer insulating film 14, and is disposed on the substrate 11, the gate electrode 12b, or the gate electrode 13b. Fig. 2 illustrates a plug 15a, a plug 15b, a plug 15c, and a plug 15d as examples of the contact plug 15. The plug 15a is disposed on the diffusion region 11d. The plug 15b is disposed on the gate electrode 12b. The plug 15c is disposed on the diffusion region 11c. The plug 15d is disposed on the gate electrode 13b. The plugs 15a, 15b, 15c, and 15d are, for example, P-type, N-type, N-type, and N-type semiconductor layers (for example, polysilicon layers), respectively.

The wiring layer 16 is formed in the interlayer insulating film 14 and is disposed on the contact plug 15. In Fig. 2, the wiring layer 16 includes wirings 16a, 16b, and 16c separated from each other. The wiring 16a is disposed on the plug 15a. The wiring 16b is disposed on the plug 15b. The wiring 16c is disposed on the plugs 15c and 15d, and electrically connects the plug 15c and the plug 15d. The wirings 16a, 16b, and 16c are, for example, P-type, N-type, and N-type semiconductor layers (for example, polysilicon layers), respectively. The wirings 16a to 16c are also referred to as local wirings. The wirings 16a to 16c are examples of a first wiring of the present disclosure.

The substrate 21 is disposed on the interlayer insulating film 14. The solid-state imaging device of the present embodiment is formed by the substrates 11 and 21 bonded to each other. The substrate 21 is bonded to the substrate 11 via the interlayer insulating film 14. The substrate 21 is, for example, a semiconductor substrate such as a silicon substrate. In Fig. 2, the X direction and the Y direction are parallel to an upper surface of the substrate 21, and the Z direction is perpendicular to the upper surface of the substrate 21.

The insulating film 22 is embedded in an opening provided in the substrate 21. This opening penetrates the substrate 21. Therefore, the insulating film 22 is disposed on the interlayer insulating film 14 similarly to the substrate 21. The insulating film 22 is, for example, a silicon oxide film.

The pixel transistor 23 includes a gate insulating film 23a and a gate electrode 23b sequentially formed on the substrate 21. The gate insulating film 23a is, for example, a silicon oxide film. The gate electrode 23b is, for example, an N-type semiconductor layer (for example, a polysilicon layer). The pixel transistor 23 is, for example, a selection transistor SEL.

The interlayer insulating film 24 is formed on the substrate 21, the insulating film 22, and the pixel transistor 23, and covers the pixel transistor 23. The interlayer insulating film 24 is, for example, a multilayer insulating film including a silicon oxide film and another insulating film.

Each of the contact plugs 25 is formed in the interlayer insulating film 24 and is disposed on the substrate 21 or the gate electrode 23b. Fig. 2 illustrates a plug 25a, a plug 25b, and a plug 25c as examples of the contact plug 25. The plug 25a is disposed on the gate electrode 23b. The plug 25b is disposed on a diffusion region (not illustrated) formed in the substrate 21. The plug 25c is disposed on another diffusion region (not illustrated) formed in the substrate 21. These diffusion regions function as source and drain regions of the pixel transistor 23. The plugs 25a, 25b, and 25c are, for example, N-type, N-type, and N-type semiconductor layers (for example, polysilicon layers), respectively.

The through plug 31 is formed in the interlayer insulating film 14, the insulating film 22, and the interlayer insulating film 24, and penetrates the substrate 21. The insulating film 22 is interposed between the substrate 21 and each through plug 31, and electrically insulates the substrate 21 from each through plug 31. The through plug 31 has, for example, a columnar shape extending in the Z direction, a lower end of the through plug 31 is located in the interlayer insulating film 16, and an upper end of the through plug 31 is located in the interlayer insulating film 24. Each through plug 31 is, for example, a metal layer. Each through plug 31 includes, for example, an aluminum (Al) layer, a tungsten (W) layer, or a copper (Cu) layer. Fig. 2 illustrates a plug 31a and a plug 31b as examples of the through plug 31. The plug 31a is disposed on the wiring 16a and is electrically connected to the wiring 16a. The plug 31b is disposed on the wiring 16b and is electrically connected to the wiring 16b. Note that each through plug 31 is disposed, for example, under a wiring (not illustrated) provided in the interlayer insulating film 24, and is electrically connected to the wiring. The through plug 31 is also referred to as a TCS.

The solid-state imaging device of the present embodiment has a two-layer structure including the substrate 11 (first layer) and the substrate 21 (second layer). A region in the substrate 11 and the interlayer insulating film 14 is referred to as "first floor", and a region in the substrate 21 and the interlayer insulating film 24 is referred to as "second floor". For example, the photodiode PD, the floating diffusion section FD, and the pixel transistors 12 and 13 are disposed on the first floor, and the pixel transistor 23 is disposed on the second floor. Furthermore, the through plug 31 is disposed across the first floor and the second floor.

Note that the pixel transistors 12, 13, and 23 may be transistors other than the transfer transistor TG, the amplification transistor AMP, and the selection transistor SEL, respectively. For example, one of the pixel transistors 12 and 13 may be a reset transistor or a switch transistor.

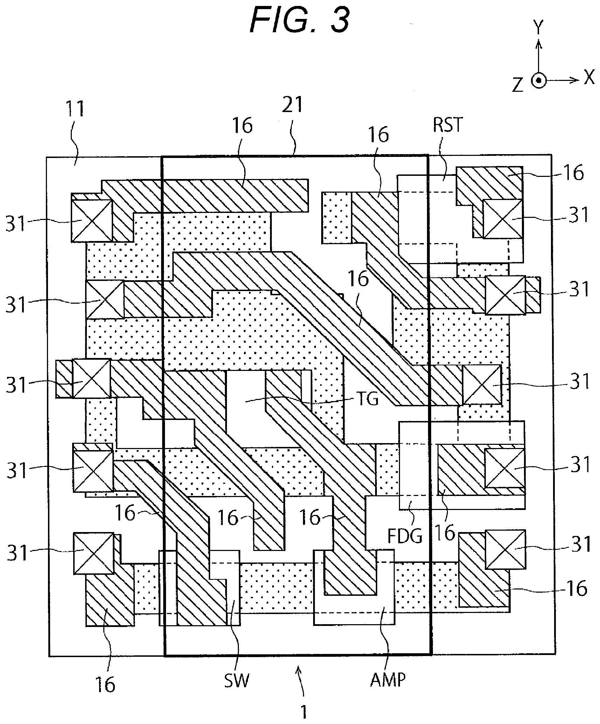

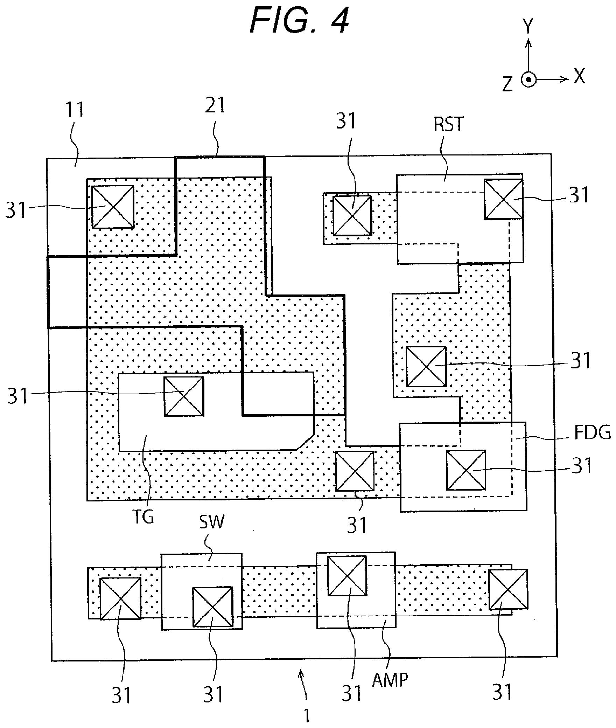

As described above, the solid-state imaging device of the present embodiment includes the plugs 31a and 31b (through plug 31) penetrating the substrate 21. When the plugs 31a and 31b are disposed in the substrate 21, there is a possibility that the presence of the plugs 31a and 31b becomes an obstacle and it becomes difficult to dispose the pixel transistor 23 on the substrate 21. However, according to the present embodiment, by disposing the plugs 31a and 31b on the wirings 16a and 16b, the plugs 31a and 31b can be disposed in the substrate 21 so that the pixel transistor 23 can be easily disposed on the substrate 21. The reason is that by disposing the wirings 16a and 16b at suitable positions, the plugs 31a and 31b can be disposed at positions that do not interfere with the placement of the pixel transistor 23. Details of such an effect will be described later with reference to Figs. 3 and 4.

Fig. 3 is a plan view illustrating a structure of the solid-state imaging device of the first embodiment. Similarly to Fig. 2, Fig. 3 illustrates one pixel 1 in the solid-state imaging device of the present embodiment.

Fig. 3 illustrates the transfer transistor TG, the reset transistor RST, the amplification transistor AMP, the switch transistor SW, and the capacitance transistor FDG provided in the interlayer insulating film 14 on the substrate 11. Specifically, in Fig. 3, a range in which the gate electrodes of these pixel transistors are provided is indicated by a quadrangle or the like. These pixel transistors are disposed on the first floor of the solid-state imaging device of the present embodiment. On the other hand, the selection transistor SEL (see Fig. 2) is disposed on the second floor of the solid-state imaging device of the present embodiment. Note that the transfer transistor TG and the amplification transistor AMP illustrated in Fig. 3 are not provided in the same XZ cross section, but the transfer transistor TG and the amplification transistor AMP illustrated in Fig. 2 are drawn in the same XZ cross section for easy understanding of the description.

Fig. 3 further illustrates the substrate 21 disposed above the substrate 11. The solid-state imaging device according to the present embodiment includes the insulating film 22 (see Fig. 2) embedded in the opening provided in the substrate 21. A region within a thick line illustrated in Fig. 3 indicates a region where the substrate 21 exists, and a region outside the thick line illustrated in Fig. 3 indicates a region where the insulating film 22 exists.

Fig. 3 further illustrates a plurality of the wirings included in the wiring layer 16 and the plurality of through plugs 31 penetrating the substrate 21. Since the through plug 31 passes through the opening, the insulating film 22 is interposed between the substrate 21 and the through plug 31.

Fig. 4 is a plan view illustrating a structure of a solid-state imaging device according to a comparative example of the first embodiment. Fig. 4 illustrates one pixel 1 in the solid-state imaging device of the present comparative example.

Similarly to Fig. 3, Fig. 4 illustrates various pixel transistors provided in the interlayer insulating film 14 on the substrate 11, the substrate 21 disposed above the substrate 11, and the plurality of through plugs 31 penetrating the substrate 21.

Next, Fig. 3 (first embodiment) is compared with Fig. 4 (comparative example).

In Fig. 4, the through plugs 31 are disposed at various places in the pixel 1. Therefore, an area of the substrate 21 in the pixel 1, that is, an area of the region in the thick line illustrated in Fig. 4 is set to be narrow. The reason is that it is necessary to set the area of the opening to be large in order to dispose the through plugs 31 at various places in the pixel 1, and as a result, the area of the substrate 21 in the pixel 1 is reduced. This means that the area in which the selection transistor SEL can be disposed is narrowed, and it is difficult to dispose the selection transistor SEL. As described above, the through plugs 31 of the present comparative example hinders the placement of the pixel transistors such as the selection transistor SEL on the substrate 21.

On the other hand, the through plugs 31 illustrated in Fig. 3 are collectively disposed in the vicinity of a left end and the vicinity of a right end in the pixel 1. As a result, the area of the substrate 21 in the pixel 1, that is, the area of the region in the thick line illustrated in Fig. 3 is set to be wide. Therefore, the area in which the selection transistor SEL can be disposed is increased, and the selection transistor SEL can be easily disposed. As described above, according to the present embodiment, the through plugs 31 can be disposed at positions that do not interfere with the placement of the pixel transistors such as the selection transistor SEL.

In Fig. 3, some pixel transistors are disposed immediately below the substrate 21, that is, immediately below the region within the thick line illustrated in Fig. 3. When the through plugs 31 are disposed in the vicinity of these pixel transistors, it is necessary to narrow the area of the substrate 21 in the pixel 1. The reason is that it is necessary to provide the opening near the through plugs 31. However, in the present embodiment, some wirings in the wiring layer 16 extend from these pixel transistors to the vicinity of the left end and the vicinity of the right end in the pixel 1, and the through plugs 31 are disposed on these wirings. As a result, the through plugs 31 can be collectively disposed in the vicinity of the left end or the vicinity of the right end in the pixel 1. As described above, according to the present embodiment, by disposing the wirings in the wiring layer 16 at suitable positions, the through plugs 31 can be disposed at positions that do not interfere with the placement of the pixel transistors such as the selection transistor SEL.

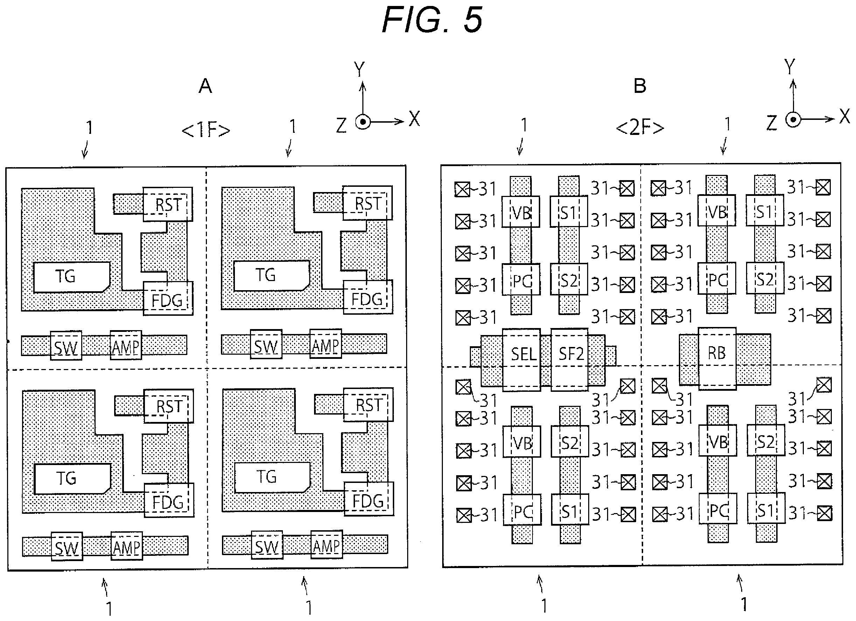

Fig. 5 is another plan view illustrating a structure of the solid-state imaging device of the first embodiment.

A of Fig. 5 illustrates a structure on the first floor of four pixels 1 in the solid-state imaging device of the present embodiment. In A of Fig. 5, each pixel 1 includes the transfer transistor TG, the reset transistor RST, the amplification transistor AMP, the switch transistor SW, and the capacitance transistor FDG. The structure illustrated in A of Fig. 5 is the same as the structure illustrated in Fig. 3. However, in A of Fig. 5, illustration of the wiring layer 16 and the through plugs 31 is omitted.

B of Fig. 5 illustrates a structure on the second floor of the four pixels 1 in the solid-state imaging device of the present embodiment. In B of Fig. 5, each pixel 1 includes a switch transistor S1, a switch transistor S2, a current source transistor PC, and a post-stage current source transistor VB. Furthermore, the four pixels 1 illustrated in B of Fig. 5 share the selection transistor SEL, a post-stage amplification transistor SF2, and a VREG voltage transistor RB.

B of Fig. 5 further illustrates the plurality of through plugs 31 provided in each pixel 1. These through plugs 31 are collectively disposed in the vicinity of the left end and the vicinity of the right end in each pixel 1. According to the present embodiment, the through plugs 31 can be disposed at positions that do not interfere with the placement of the switch transistor S1, the switch transistor S2, the current source transistor PC, the post-stage current source transistor VB, the selection transistor SEL, the post-stage amplification transistor SF2, and the VREG voltage transistor RB.

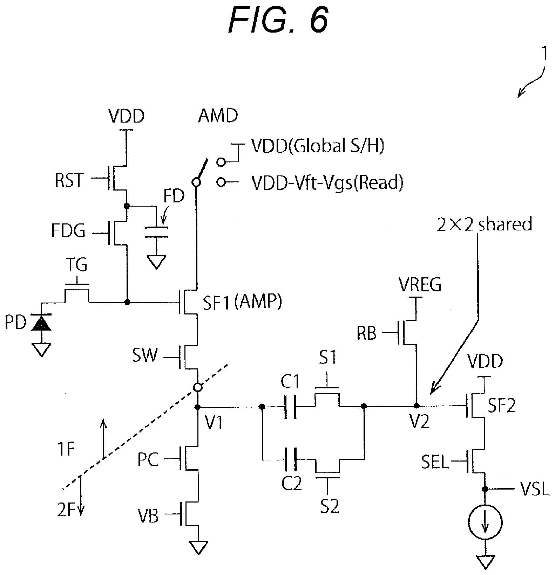

Fig. 6 is a circuit diagram illustrating a configuration of the solid-state imaging device of the first embodiment.

As illustrated in Fig. 6, each pixel 1 includes the photodiode PD, the floating diffusion section FD, the transfer transistor TG, the reset transistor RST, the capacitance transistor FDG, the amplification transistor SF1 (= AMP), and the switch transistor SW. Each pixel 1 further includes the current source transistor PC, the post-stage current source transistor VB, capacitors C1 and C2, the switch transistors S1 and S2, the VREG voltage transistor RB, the post-stage amplification transistor SF2, and the selection transistor SEL. At least one of these transistors may be shared by a plurality of the pixels 1. The solid-state imaging device of the present embodiment is a voltage domain type CIS (VD-GS) that realizes a global shutter function by simultaneously converting charges generated in the photodiodes PD into voltages in all the pixels 1 and holding the voltages until reading is completed.

Each of the photodiodes PD performs photoelectric conversion of incident light. An anode of the photodiode PD is electrically connected to the ground potential, and a cathode of the photodiode PD is electrically connected to the transfer transistor TG. Incident light into the photodiode PD is referred to as exposure of the photodiode PD.

The transfer transistor TG transfers charges generated by the above-described photoelectric conversion to the floating diffusion section FD. One of the source and the drain of the transfer transistor TG is electrically connected to the photodiode PD, and the other of the source and the drain of the transfer transistor TG is electrically connected to the capacitance transistor FDG and the amplification transistor SF1.

The floating diffusion section FD accumulates the charges transferred by the transfer transistor TG. As illustrated in Fig. 6, the floating diffusion section FD functions as a capacitor. The floating diffusion section FD is electrically connected to the capacitance transistor FDG and the reset transistor RST.

The reset transistor RST discharges the charges from the floating diffusion section FD and resets the potential of the floating diffusion section FD to a power supply voltage (VDD) before the exposure of the photodiode PD is started. One of the source and the drain of the reset transistor RST is electrically connected to the power supply voltage, and the other of the source and the drain of the reset transistor RST is electrically connected to the floating diffusion section FD and the capacitance transistor FDG.

The capacitance transistor FDG functions as a switch that switches the conversion efficiency of photoelectric conversion by the photodiode PD. One of the source and the drain of the capacitance transistor FDG is electrically connected to the floating diffusion section FD and the reset transistor RST, and the other of the source and the drain of the capacitance transistor FDG is electrically connected to the transfer transistor TG and the amplification transistor SF1.

The amplification transistor SF1 receives the charges transferred to the floating diffusion section FD at a gate, and outputs the charges to the switch transistor SW by a source follower. The gate of the amplification transistor SF1 is electrically connected to the transfer transistor TG and the capacitance transistor FDG. One of the source and the drain of the amplification transistor SF1 is electrically connected to the power supply voltage, and the other of the source and the drain of the amplification transistor SF1 is electrically connected to the switch transistor SW.

The switch transistor SW can electrically connect the amplification transistor SF1 and the capacitors C1 and C2. When the switch transistor SW is turned on, the amplification transistor SF1 and the capacitors C1 and C2 are electrically connected, and when the switch transistor SW is turned off, the amplification transistor SF1 and the capacitors C1 and C2 are electrically insulated. One of the source and the drain of the switch transistor SW is electrically connected to the amplification transistor SF1, and the other of the source and the drain of the switch transistor SW is electrically connected to the current source transistor PC and the capacitors C1 and C2.

The capacitors C1 and C2 are electrically connected to a node V1 between the switch transistor SW and the current source transistor PC. One electrode of the capacitor C1 is electrically connected to the node V1, and the other electrode of the capacitor C1 is electrically connected to the switch transistor S1. One electrode of the capacitor C2 is electrically connected to the node V1, and the other electrode of the capacitor C2 is electrically connected to the switch transistor S2. The capacitors C1 and C2 are connected in parallel to the node V1.

The switch transistor S1 can electrically connect the capacitor C1 and the post-stage amplification transistor SF2. When the switch transistor S1 is turned on, the capacitor C1 and the post-stage amplification transistor SF2 are electrically connected, and when the switch transistor S1 is turned off, the capacitor C1 and the post-stage amplification transistor SF2 are electrically insulated. One of the source and the drain of the switch transistor S1 is electrically connected to the capacitor C1, and the other of the source and the drain of the switch transistor S1 is electrically connected to the VREG voltage transistor RB and the post-stage amplification transistor SF2.

The switch transistor S2 can electrically connect the capacitor C2 and the post-stage amplification transistor SF2. When the switch transistor S2 is turned on, the capacitor C2 and the post-stage amplification transistor SF2 are electrically connected, and when the switch transistor S2 is turned off, the capacitor C2 and the post-stage amplification transistor SF2 are electrically insulated. One of the source and the drain of the switch transistor S2 is electrically connected to the capacitor C2, and the other of the source and the drain of the switch transistor S2 is electrically connected to the VREG voltage transistor RB and the post-stage amplification transistor SF2.

The VREG voltage transistor RB is electrically connected to a node V2 between the switch transistors S1 and S2 and the post-stage amplification transistor SF2. When the VREG voltage transistor RB is turned on, the VREG voltage is supplied to the node V2.

The post-stage amplification transistor SF2 receives the charges output from the capacitors C1 and C2 at a gate, and outputs the charges to the vertical signal line 8 (VSL) by a source follower. The gate of the post-stage amplification transistor SF2 is electrically connected to the capacitors C1 and C2 and the VREG voltage transistor RB. One of the source and the drain of the post-stage amplification transistor SF2 is electrically connected to the power supply voltage, and the other of the source and the drain of the post-stage amplification transistor SF2 is electrically connected to the selection transistor SEL.

The selection transistor SEL can electrically connect the post-stage amplification transistor SF2 and the vertical signal line 8. When the selection transistor SEL is turned on, the post-stage amplification transistor SF2 and the vertical signal line 8 are electrically connected, and when the selection transistor SEL is turned off, the post-stage amplification transistor SF2 and the vertical signal line 8 are electrically insulated. One of the source and the drain of the selection transistor SEL is electrically connected to the post-stage amplification transistor SF2, and the other of the source and the drain of the selection transistor SEL is electrically connected to the vertical signal line 8.

The current source transistor PC and the post-stage current source transistor VB function as current sources. One of the source and the drain of the current source transistor PC is electrically connected to the switch transistor SW, and the other of the source and the drain of the current source transistor PC is electrically connected to the post-stage current source transistor VB. One of the source and the drain of the post-stage current source transistor VB is electrically connected to the current source transistor PC.

As described above, the solid-state imaging device of the present embodiment includes the wiring layer 16 provided in the interlayer insulating film 14 on the substrate 11 and the plurality of through plugs 31 penetrating the substrate 21, and these through plugs 31 are provided on the wiring layer 16. Therefore, according to the present embodiment, it is possible to suitably dispose the through plugs 31 in the substrate 21, such as to dispose the through plugs 31 at positions that do not interfere with the placement of the transistors on the substrate 21.

### (Second embodiment)

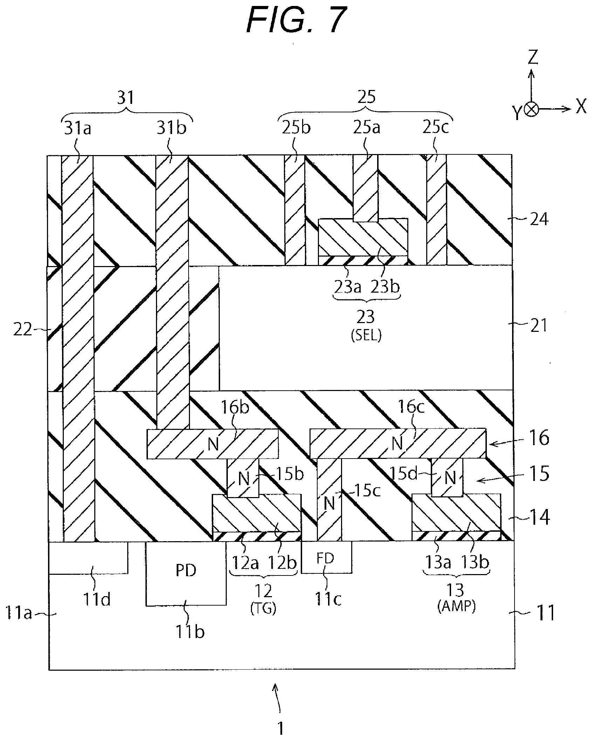

Fig. 7 is a cross-sectional view illustrating a structure of a solid-state imaging device of a second embodiment.

The solid-state imaging device (Fig. 7) of the present embodiment has a structure similar to the structure of the solid-state imaging device (Fig. 2) of the first embodiment. However, the solid-state imaging device of the present embodiment does not include the wiring 16a for a plug 31a (through plug 31) or the plug 15a, and the lower end of the plug 31a reaches an upper surface of a diffusion region 11d. Therefore, the plug 31a of the present embodiment is electrically connected to a substrate 11 by being directly formed on the substrate 11. The plug 31a of the present embodiment is an example of a second plug of the present disclosure.

As illustrated in Fig. 7, the plug 31a is disposed directly above the diffusion region 11d, that is, in the Z direction of the diffusion region 11d. Therefore, the plug 31a can be disposed on the diffusion region 11d by increasing the length of the plug 31a in the Z direction instead of disposing the plug 31a on the wiring 16a (Fig. 2) described above. Therefore, in the present embodiment, a structure in which the wiring 16a and the plug 15a are not provided is adopted.

The contact plug 15 and the wiring layer 16 of the first embodiment include the plug 15a and the wiring 16a that are P-type layers, and the plugs 15b to 15d and the wirings 16b to 16c that are N-type layers. On the other hand, a contact plug 15 and a wiring layer 16 of the present embodiment do not include the P-type layer, but include only plugs 15b to 15d and wirings 16b and 16c that are N-type layers. Therefore, according to the present embodiment, the contact plug 15 and the wiring layer 16 can be easily formed as compared with the first embodiment. On the other hand, according to the first embodiment, the plurality of through plugs 31 can be easily formed by making the lengths of the plurality of through plugs 31 in the Z direction the same.

### (Third embodiment)

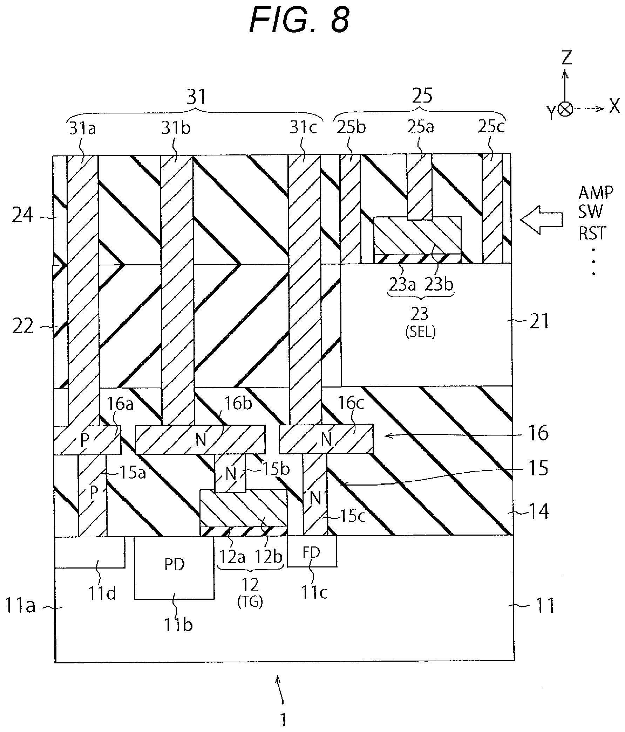

Fig. 8 is a cross-sectional view illustrating a structure of a solid-state imaging device of a third embodiment.

The solid-state imaging device (Fig. 8) of the present embodiment has a structure similar to the structure of the solid-state imaging device (Fig. 2) of the first embodiment. However, in order to utilize the fact that an area of a substrate 21 in each pixel 1 is wide, the solid-state imaging device according to the present embodiment includes an amplification transistor AMP, a switch transistor SW, a reset transistor RST, and the like on the substrate 21 in addition to a selection transistor SEL. As a result, it is possible to reduce an area of a substrate 11 per pixel 1, and thus, it is possible to reduce the size (area) of the solid-state imaging device in plan view.

A through plug 31 of the present embodiment includes a plug 31c in addition to plugs 31a and 31b. The plug 31c is disposed on a wiring 16c, and is electrically connected to a diffusion region 11c (floating diffusion section FD) via the wiring 16c and a plug 15c. Since the amplification transistor AMP of the present embodiment is disposed on the substrate 21, the gate electrode of the amplification transistor AMP of the present embodiment is electrically connected to the diffusion region 11c via the plug 31c, the wiring 16c, and the plug 15c. Note that, similarly to the plug 31a of the second embodiment, the plug 31c may be directly formed on the diffusion region 11c.

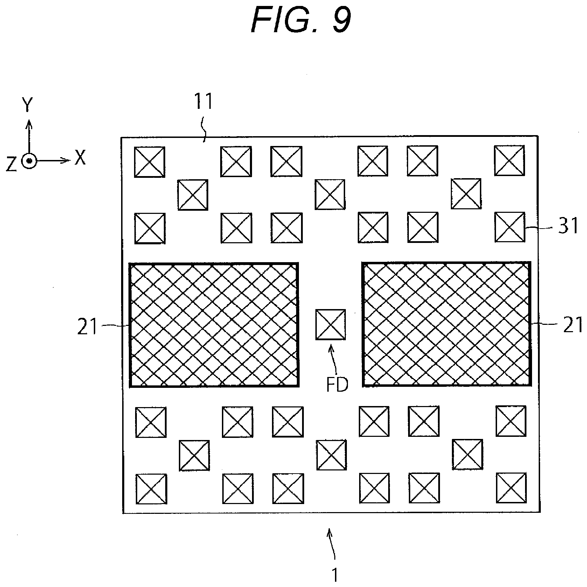

Fig. 9 is a plan view illustrating a structure of the solid-state imaging device according to the third embodiment. Similarly to Fig. 3, Fig. 9 schematically illustrates a planar structure of one pixel 1 of the present embodiment.

In Fig. 9, a region where the substrate 21 is present in the pixel 1 is indicated by cross hatching in a thick line. In the present embodiment, the area of the region where the substrate 21 is present is large. Fig. 9 further illustrates a plurality of the through plugs 31 penetrating the substrate 21. In the present embodiment, these through plugs 31 are collectively disposed in the vicinity of an upper end and the vicinity of a lower end in the pixel 1. However, only one through plug 31 is disposed near the floating diffusion section FD. In Fig. 9, the position where the floating diffusion section FD is provided is indicated by a broken arrow. The through plug 31 disposed in the vicinity of the floating diffusion section FD corresponds to the plug 31c illustrated in Fig. 8.

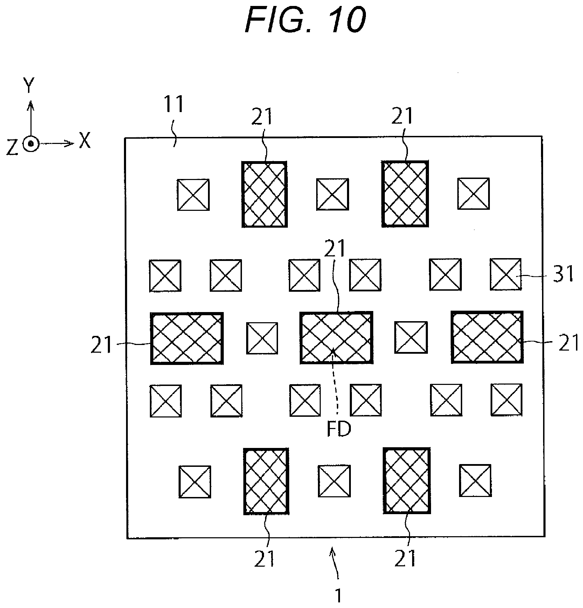

Fig. 10 is a plan view illustrating a structure of a solid-state imaging device of a comparative example of the third embodiment. Fig. 10 schematically illustrates a planar structure of one pixel 1 of the present comparative example.

Fig. 10 also illustrates a region where the substrate 21 is present in the pixel 1, the plurality of through plugs 31 penetrating the substrate 21, and a position where the floating diffusion section FD is provided. In the present comparative example, these through plugs 31 are disposed at various places in the pixel 1, and the area of the region where the substrate 21 exists is reduced.

As described above, the solid-state imaging device according to the present embodiment includes the amplification transistor AMP, the switch transistor SW, the reset transistor RST, and the like on the substrate 21 in addition to the selection transistor SEL. Therefore, according to the present embodiment, the size of the solid-state imaging device in plan view can be reduced.

### (Fourth embodiment)

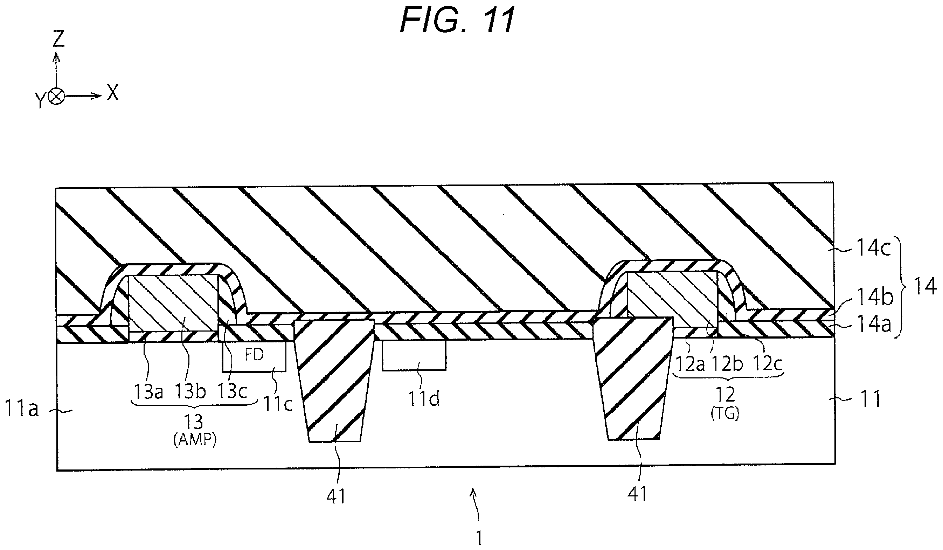

Figs. 11 to 20 are cross-sectional views illustrating a manufacturing method of a solid-state imaging device according to a fourth embodiment. According to the method of the present embodiment, for example, the solid-state imaging device of the first embodiment can be manufactured.

First, a well region 11a, a diffusion region 11b (not illustrated), a diffusion region 11c, and a diffusion region 11d are formed in a substrate 11 (Fig. 11). As a result, a floating diffusion section FD and a photodiode PD (not illustrated) are also formed in the substrate 11. Next, an insulating film 14a constituting an interlayer insulating film 14 is formed on the substrate 11, and an element isolation insulating film 41 is formed in the substrate 11 and the insulating film 14a (Fig. 11).

Next, a plurality of openings is formed in the insulating film 14a, and pixel transistors 12 and 13 are formed on the substrate 11 in the openings (Fig. 11). The pixel transistor 12 is formed by sequentially forming a gate insulating film 12a and a gate electrode 12b on the substrate 11 and forming sidewall insulating films 12c on both side surfaces of the gate electrode 12b. Similarly, the pixel transistor 13 is formed by sequentially forming a gate insulating film 13a and a gate electrode 13b on the substrate 11 and forming sidewall insulating films 13c on both side surfaces of the gate electrode 13b. Other pixel transistors on the substrate 11 are similarly formed.

Next, insulating films 14b and 14c constituting the interlayer insulating film 14 are sequentially formed on the pixel transistors 12 and 13, the insulating film 14a, and the element isolation insulating film 41, and thereafter, an upper surface of the insulating film 14c is planarized by chemical mechanical polishing (CMP) (Fig. 11). The insulating films 14a to 14c are examples of a first portion of the first insulating film of the present disclosure.

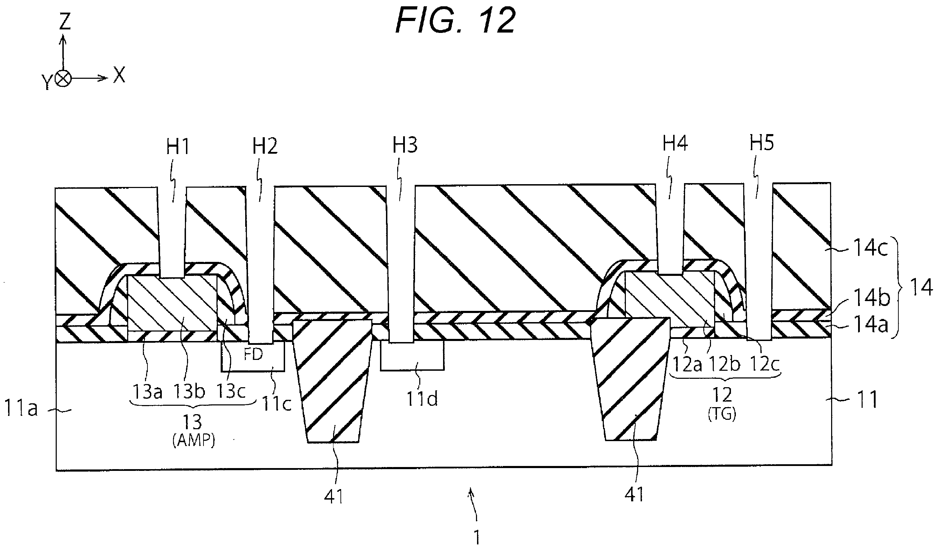

Next, contact holes H1, H2, H3, H4, and H5 penetrating the insulating films 14a to 14c are formed by photolithography and reactive ion etching (RIE) (Fig. 12). The contact hole H1 is formed so as to reach an upper surface of the gate electrode 13b. The contact hole H2 is formed so as to reach an upper surface of the diffusion region 11c. The contact hole H3 is formed so as to reach an upper surface of the diffusion region 11d. The contact hole H4 is formed so as to reach an upper surface of the gate electrode 12b. The contact hole H5 is formed so as to reach an upper surface of the substrate 11.

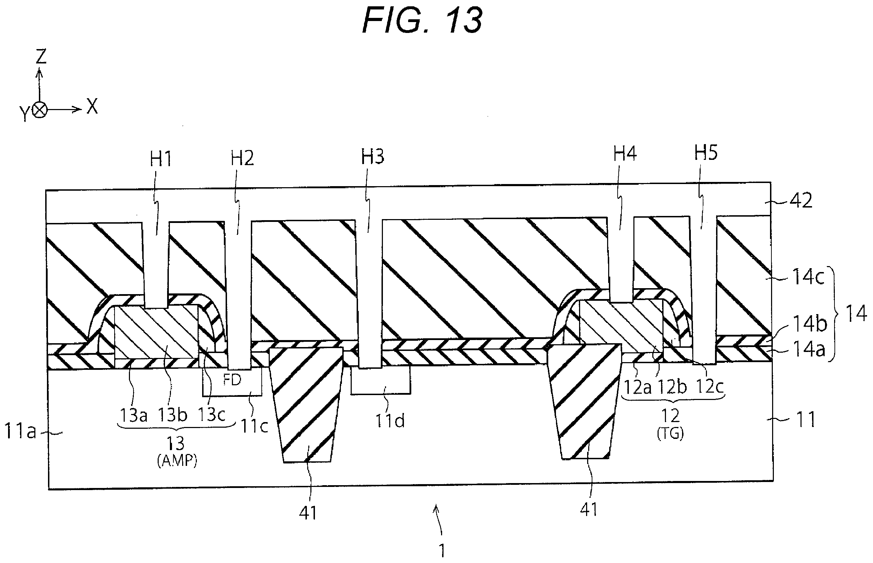

Next, a semiconductor layer 42 is formed on the entire surface of the substrate 11 (Fig. 13). As a result, the semiconductor layer 42 is formed in the contact holes H1 to H5 and on the insulating film 14c. The semiconductor layer 42 is, for example, a polysilicon layer having heat resistance. Note that, in the step illustrated in Fig. 13, another layer having a heat resistant layer may be formed instead of the semiconductor layer 42. Examples of such a layer are metal layers such as a tungsten (W) layer and a ruthenium (Ru) layer.

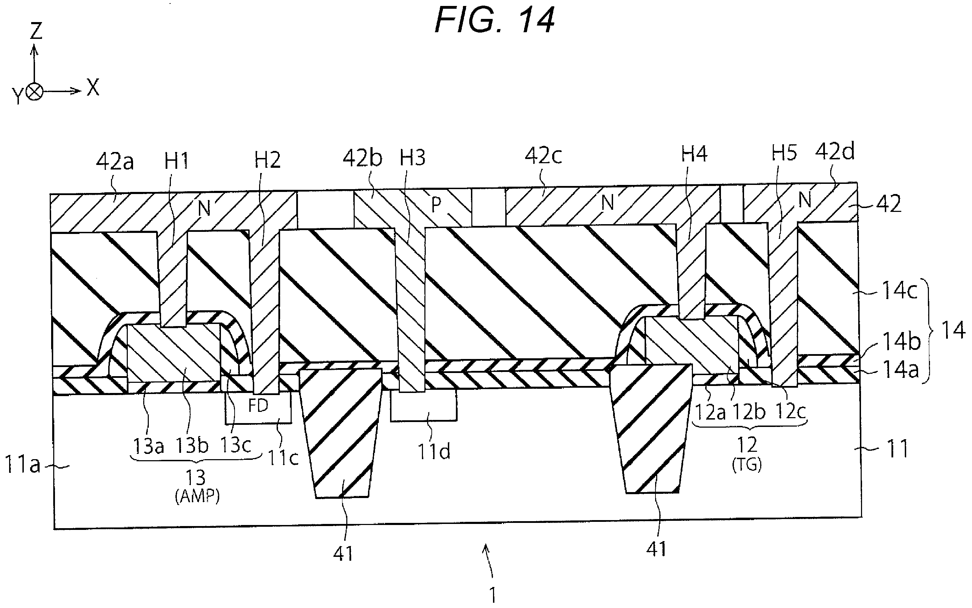

Next, an N-type impurity is implanted into a predetermined region of the semiconductor layer 42, and a P-type impurity is implanted into another predetermined region of the semiconductor layer 42 (Fig. 14). As a result, N-type regions 42a, 42c, and 42d are formed in the semiconductor layer 42 in or near the contact holes H1, H2, H4, and H5, and P-type region 42b is formed in the semiconductor layer 42 in or near the contact hole H3. When the N-type impurity is implanted, an upper surface of the semiconductor layer 42 other than a portion where the N-type regions 42a, 42c, and 42d are to be formed is covered with a mask layer. Similarly, when the P-type impurity is implanted, the upper surface of the semiconductor layer 42 other than a portion where the P-type region 42b is to be formed is covered with a mask layer.

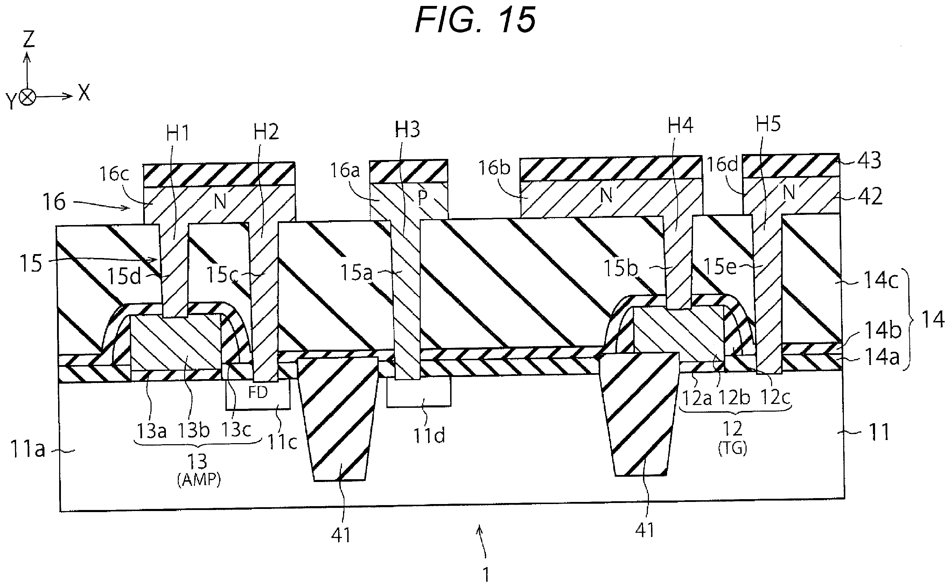

Next, a mask layer 43 is formed on the entire surface of the substrate 11, and the mask layer 43 is processed by photolithography and RIE (Fig. 15). At this time, the mask layer 43 is processed so as to remain on the N-type regions 42a, 42c, and 42d and the P-type region 42b.

Next, the semiconductor layer 42 is processed by RIE using the mask layer 43 (Fig. 15). As a result, the semiconductor layer 42 is divided into the N-type region 42a, the P-type region 42b, the N-type region 42c, and the N-type region 42d. The N-type region 42a in the contact hole H1, the N-type region 42a in the contact hole H2, the P-type region 42b in the contact hole H3, the N-type region 42c in the contact hole H4, and the N-type region 42d in the contact hole H5 become a plug 15d, a plug 15c, a plug 15a, a plug 15b, and a plug 15e (contact plug 15), respectively. The N-type region 42a on the contact holes H1 and H2, the P-type region 42b on the contact hole H3, the N-type region 42c on the contact hole H4, and the N-type region 42d on the contact hole H5 become the wiring 16c, the wiring 16a, the wiring 16b, and the wiring 16d in the wiring layer 16, respectively. All of the N-type regions 42a, 42c, and 42d are formed on an N-type layer such as in the substrate 11, and the P-type region 42b is formed on a P-type layer in the substrate 11.

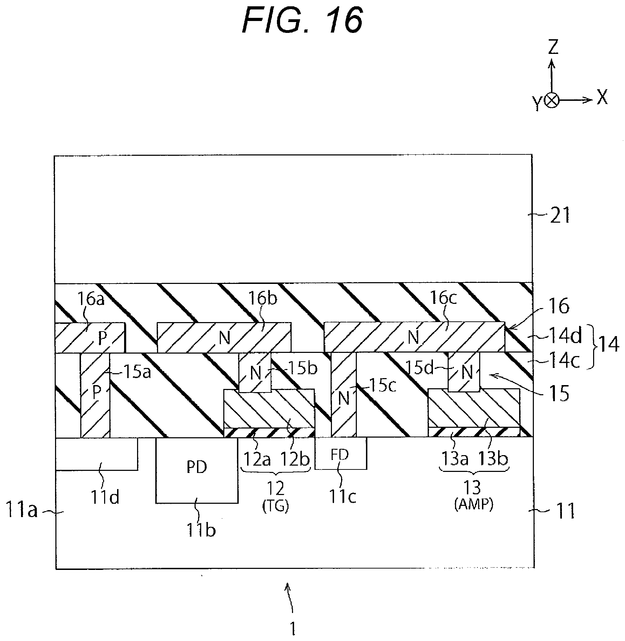

Next, the continuation of the manufacturing method of the solid-state imaging device of the present embodiment will be described with reference to Figs. 16 to 20. The cross-sectional views of Figs. 16 to 20 are drawn in a manner similar to the cross-sectional view of Fig. 2.

Next, an insulating film 14d constituting the interlayer insulating film 14 is formed on the insulating film 14c and the wiring layer 16, and then an upper surface of the insulating film 14d is planarized by CMP (Fig. 16). The insulating film 14d is an example of a second portion of the first insulating film of the present disclosure. Note that, in Fig. 16, illustration of the insulating films 14a and 14b is omitted. Next, the substrate 11 and the substrate 21 are bonded to each other with the interlayer insulating film 14 interposed therebetween (Fig. 16). As a result, the substrate 21 is disposed on the interlayer insulating film 14 (insulating film 14d).

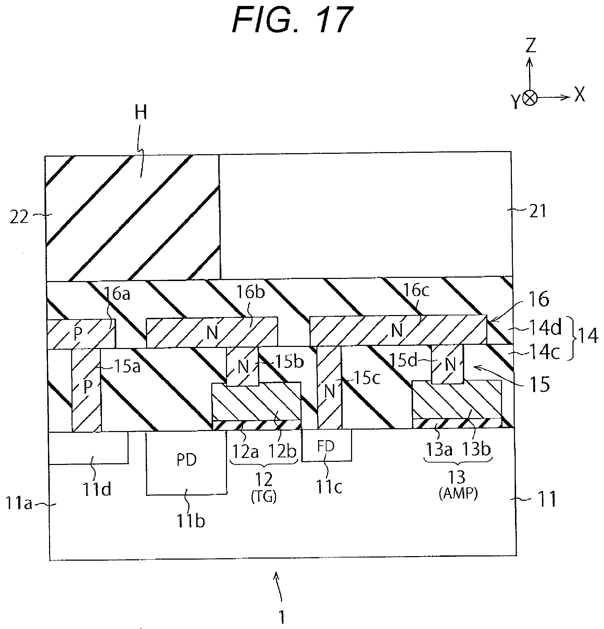

Next, an opening H is formed in the substrate 21 (Fig. 17). Next, an insulating film 22 is embedded in the opening H, and then an upper surface of the insulating film 22 is planarized by CMP (Fig. 17).

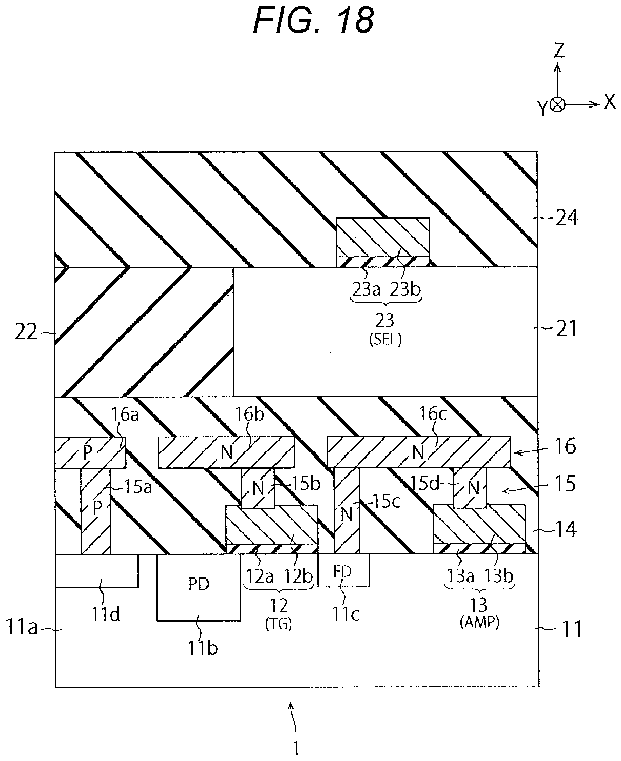

Next, a pixel transistor 23 is formed on the substrate 21 (Fig. 18). The pixel transistor 23 is formed by sequentially forming a gate insulating film 23a and a gate electrode 23b on the substrate 21 and forming sidewall insulating films (not illustrated) on both side surfaces of the gate electrode 23b. Other pixel transistors on the substrate 21 are similarly formed. Next, an interlayer insulating film 24 is formed on the substrate 21, the insulating film 22, and the pixel transistor 23, and then an upper surface of the interlayer insulating film 24 is planarized by CMP (Fig. 18).

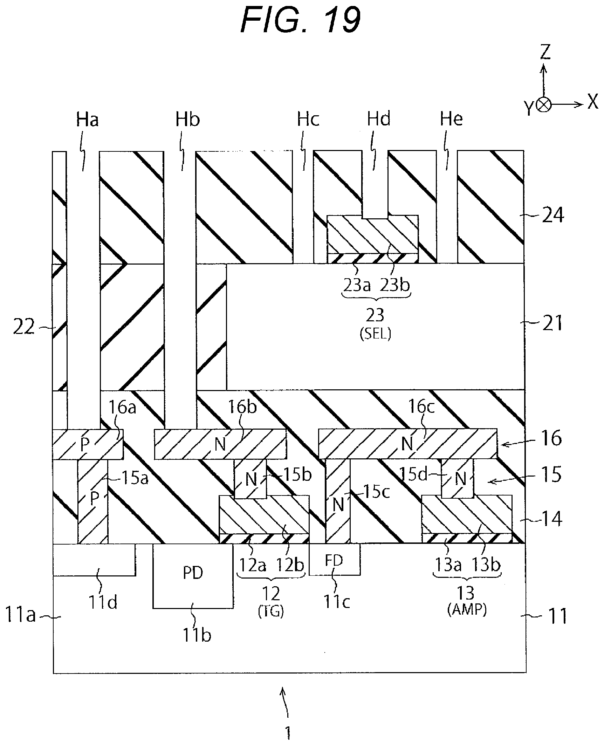

Next, through holes Ha and Hb and contact holes Hc, Hd, and He are formed in the interlayer insulating film 24, the insulating film 22, and the interlayer insulating film 14 by photolithography and RIE (Fig. 19). The through hole Ha is formed so as to reach an upper surface of the wiring 16a. The through hole Hb is formed so as to reach an upper surface of the wiring 16b. The contact hole Hc is formed so as to reach an upper surface of the substrate 21. The contact hole Hd is formed so as to reach an upper surface of the gate electrode 23b. The contact hole He is formed so as to reach the upper surface of the substrate 21. The step of forming the through holes Ha and Hb may be performed simultaneously with the step of forming the contact holes Hc to He, or may be performed before or after the step of forming the contact holes Hc, Hd, and He.

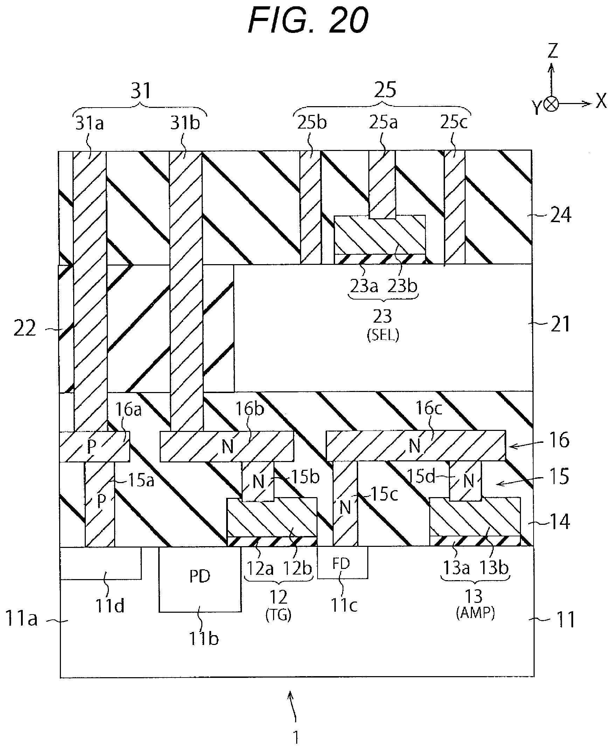

Next, a material for forming a plug is embedded in the through holes Ha and Hb and the contact holes Hc, Hd, and He (Fig. 20). As a result, plugs 31a and 31b (through plugs 31) are formed in the through holes Ha and Hb, respectively, and plugs 25b, 25a, and 25c (contact plugs 25) are formed in the contact holes Hc, Hd, and He, respectively. The material for forming the plugs is, for example, a barrier metal layer containing a Ti (titanium) element or a Ta (tantalum) element and a plug material layer containing an Al (aluminum) element, a W (tungsten) element, or a Cu (copper) element. In this case, the through plug 31 and the contact plug 25 are formed by sequentially forming the barrier metal layer and the plug material layer in the through holes Ha and Hb and the contact holes Hc, Hd, and He. The step of forming the through plug 31 may be performed simultaneously with the step of forming the contact plug 25, or may be performed before or after the step of forming the contact plug 25.

According to the present embodiment, the solid-state imaging device of the first embodiment can be manufactured by the method illustrated in Figs. 11 to 20. Note that, in a case where the solid-state imaging device of the second embodiment is manufactured, the steps of forming the plug 15a and the wiring 16a are omitted, and the through hole Ha is formed so as to reach an upper surface of the diffusion region 11d. Furthermore, in a case of manufacturing the solid-state imaging device of the third embodiment, a through hole reaching an upper surface of the wiring 16c is formed together with the through holes Ha and Hb, and the plug 31c is formed in the through hole.

### (Fifth to thirteenth embodiments)

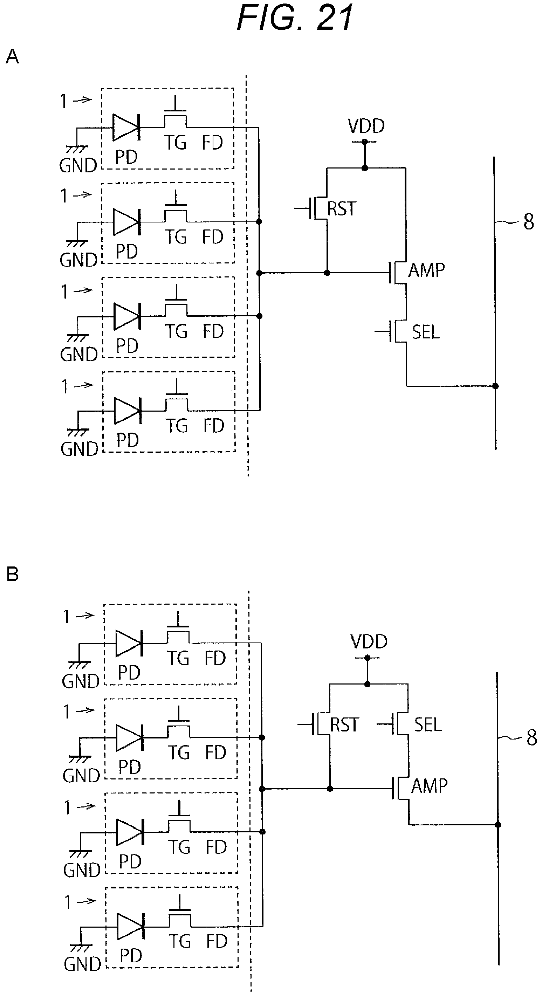

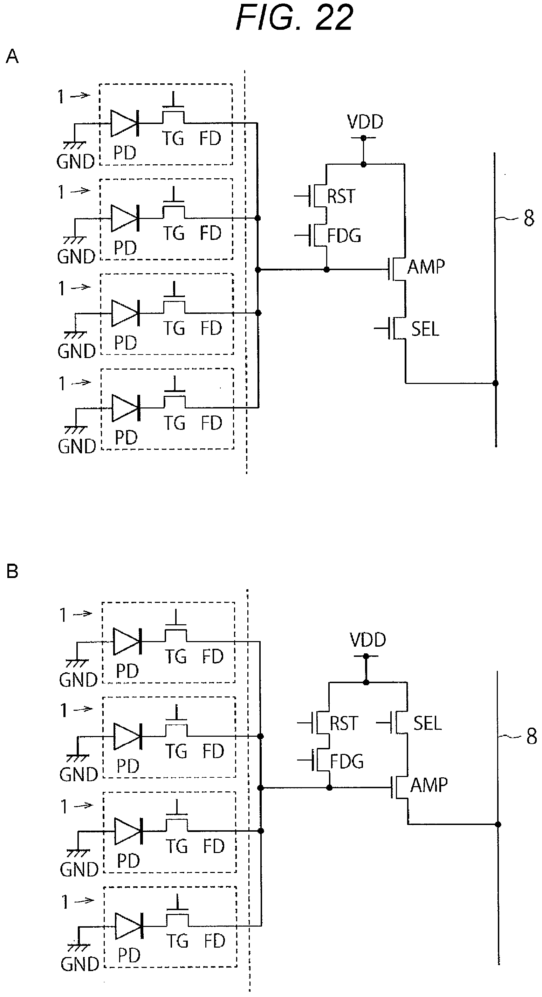

Fig. 21 is a circuit diagram illustrating configurations of solid-state imaging devices according to fifth and sixth embodiments. Fig. 22 is a circuit diagram illustrating configurations of solid-state imaging devices according to seventh and eighth embodiments.

In a solid-state imaging device of the fifth embodiment illustrated in A of Fig. 21, a reset transistor RST, an amplification transistor AMP, and a selection transistor SEL are shared by four pixels 1. Each pixel 1 includes a photodiode PD, a transfer transistor TG, and a floating diffusion section FD. The placement of these configuration elements is generally the same as the placement illustrated in Fig. 6 except that various pixel transistors and capacitors are not arranged.

A solid-state imaging device of the sixth embodiment illustrated in B of Fig. 21 has a configuration similar to the configuration of the solid-state imaging device of the fifth embodiment illustrated in A of Fig. 21. However, a selection transistor SEL of the present embodiment is disposed not between an amplification transistor AMP and a vertical signal line 8 but between the amplification transistor AMP and a power supply voltage (VDD).

A solid-state imaging device of the seventh embodiment illustrated in A of Fig. 22 has a configuration similar to the configuration of the solid-state imaging device of the fifth embodiment illustrated in A of Fig. 21. However, four pixels 1 further share a capacitance transistor FDG disposed between a reset transistor RST and an amplification transistor AMP.

A solid-state imaging device of the eighth embodiment illustrated in B of Fig. 22 has a configuration similar to the configuration of the solid-state imaging device of the sixth embodiment illustrated in A of Fig. 21. However, four pixels 1 further share a capacitance transistor FDG disposed between a reset transistor RST and an amplification transistor AMP.

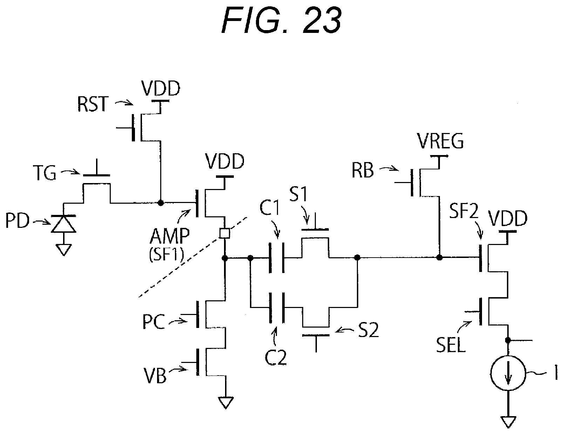

Fig. 23 is a circuit diagram illustrating a configuration of a solid-state imaging device of a ninth embodiment.

A pixel 1 illustrated in Fig. 23 has a configuration in which the capacitance transistor FDG is removed from the pixel 1 illustrated in Fig. 6. Note that a position of a floating diffusion section FD in the pixel 1 illustrated in Fig. 23 can be set, for example, similarly to each pixel 1 of the fifth to eighth embodiments.

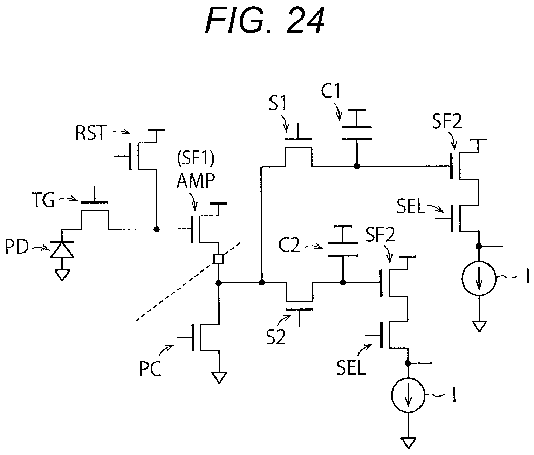

Fig. 24 is a circuit diagram illustrating a configuration of a solid-state imaging device according to a tenth embodiment.

A pixel 1 illustrated in Fig. 24 has a configuration similar to the configuration of the pixel 1 illustrated in Fig. 23, but includes another post-stage amplification transistor SF2 and another selection transistor SEL instead of the post-stage current source transistor VB and the VREG voltage transistor RB. The pixel 1 illustrated in Fig. 24 includes, in a post-stage of an amplification transistor AMP, a circuit portion including a switch transistor S1, a capacitor C1, a post-stage amplification transistor SF2, and a selection transistor SEL, and a circuit portion including a switch transistor S2, a capacitor C2, a post-stage amplification transistor SF2, and a selection transistor SEL.

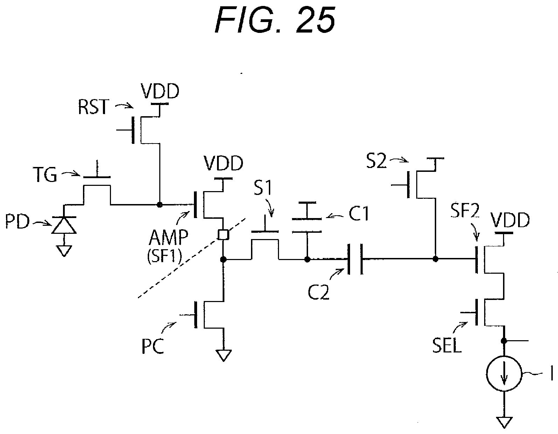

Fig. 25 is a circuit diagram illustrating a configuration of a solid-state imaging device according to an eleventh embodiment.

A pixel 1 illustrated in Fig. 25 has a configuration in which the post-stage current source transistor VB and the VREG voltage transistor RB are removed from the pixel 1 illustrated in Fig. 23. Furthermore, in Fig. 25, a switch transistor S1 is disposed at a post-stage of an amplification transistor AMP, and a capacitor C2 is disposed between the amplification transistor AMP and a post-stage amplification transistor SF2. Furthermore, in Fig. 25, the capacitor C1 is electrically connected to a node between the switch transistor S1 and the capacitor C2, and the switch transistor S2 is electrically connected to a node between the capacitor C2 and the post-stage amplification transistor SF2.

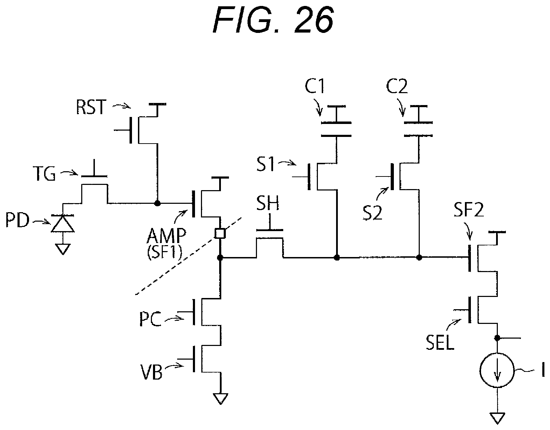

Fig. 26 is a circuit diagram illustrating a configuration of a solid-state imaging device according to a twelfth embodiment.

A pixel 1 illustrated in Fig. 26 has a configuration similar to the configuration of the pixel 1 illustrated in Fig. 23, but includes a switch transistor SH instead of the VREG voltage transistor RB. The switch transistor SH is disposed at a post-stage of an amplification transistor AMP. Furthermore, in Fig. 26, switch transistors S1 and S2 are electrically connected to a node between the switch transistor SH and a post-stage amplification transistor SF2 (parallel connection). Capacitors C1 and C2 are disposed at a post-stage of the switch transistors S1 and S2, respectively.

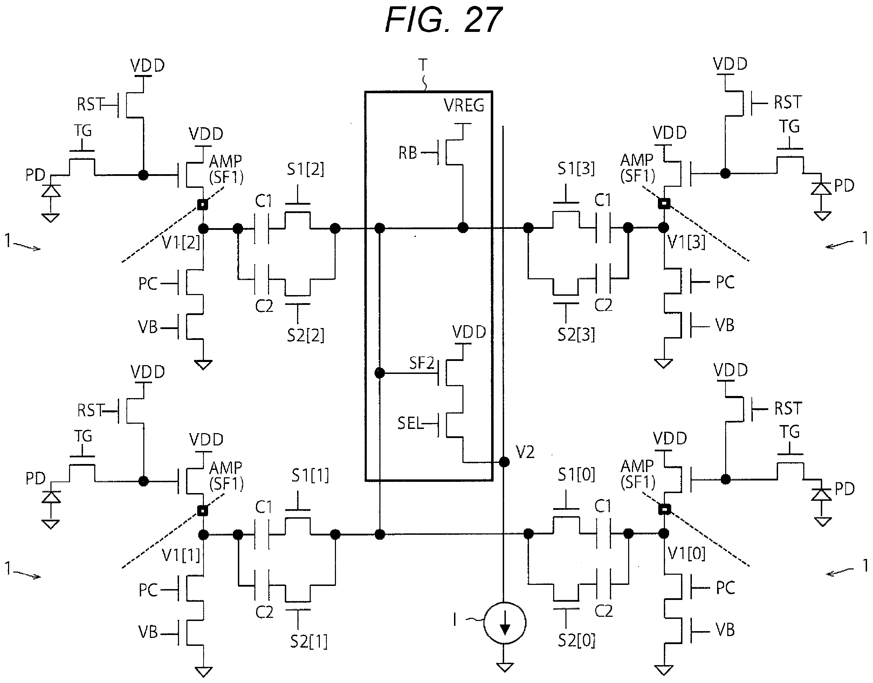

Fig. 27 is a circuit diagram illustrating a configuration of a solid-state imaging device according to a thirteenth embodiment.

Fig. 27 illustrates four pixels 1 of a solid-state imaging device of the present embodiment. Each of these pixels 1 has a configuration similar to the configuration of the pixel 1 illustrated in Fig. 23. However, these pixels 1 share a circuit portion T. The circuit portion T includes a VREG voltage transistor RB, a post-stage amplification transistor SF2, and a selection transistor SEL.

According to the fifth to thirteenth embodiments, the pixel 1 in the solid-state imaging device can be provided in various configurations. The configurations of the fifth to thirteenth embodiments may be applied to any of the pixels 1 of the first to fourth embodiments.

### (Fourteenth embodiment)

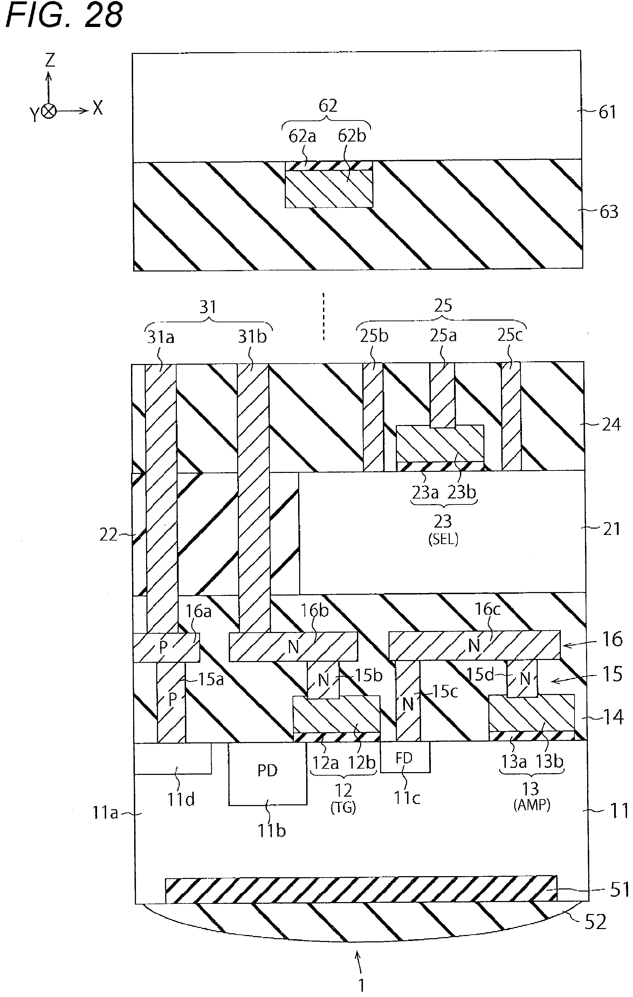

Fig. 28 is a cross-sectional view illustrating a structure of a solid-state imaging device according to a fourteenth embodiment. Similarly to Fig. 2 and the like, Fig. 28 illustrates one pixel 1 in a solid-state imaging device of the present embodiment.

The solid-state imaging device of the present embodiment includes an on-chip filter 51, an on-chip lens 52, a substrate 61, a transistor 62, and an interlayer insulating film 63, in addition to the configuration elements illustrated in Fig. 2. The substrate 61, the transistor 62, and the interlayer insulating film 63 are examples of a third substrate, a third transistor, and a third insulating film of the present disclosure, respectively.

In Fig. 28, an upper surface of the substrate 11 is a front surface of the substrate 11, and a lower surface of the substrate 11 is a back surface of the substrate 11. The solid-state imaging device according to the present embodiment is a back-illuminated type, and the lower surface (back surface) of the substrate 11 is a light incident surface (light-receiving surface) of the substrate 11. In Fig. 28, the upper surface and the lower surface of the substrate 11 are examples of a first surface and a second surface of the present disclosure, respectively.

In Fig. 28, a pixel transistor 12 and a pixel transistor 13 are formed on an upper surface side of the substrate 11, whereas the on-chip filter 51 and the on-chip lens 52 are formed on a lower surface side of the substrate 11. Specifically, the on-chip filter 51 and the on-chip lens 52 are sequentially formed below the substrate 11.

The on-chip filter 51 has a function of transmitting light having a predetermined wavelength, and is formed on the upper surface of the substrate 11 for each pixel 1. For example, the on-chip filters 51 for red (R), green (G), and blue (B) are disposed below photodiodes PD of the red, green, and blue pixels 1, respectively. Moreover, the on-chip filter 51 for infrared light may be disposed below the photodiode PD of the pixel 1 of infrared light.

The on-chip lens 52 has a function of condensing incident light, and is formed for each pixel 1 under the on-chip filter 51. In the present embodiment, light incident on the on-chip lens 52 is condensed by the on-chip lens 52, transmitted through the on-chip filter 51, and incident on the photodiode PD. The photodiode PD converts the light into a charge by photoelectric conversion to generate a signal charge.

The substrate 61 is disposed above a substrate 21. The substrate 61 is, for example, a semiconductor substrate such as a silicon substrate. In Fig. 28, the X direction and the Y direction are parallel to a lower surface of the substrate 61, and the Z direction is perpendicular to the lower surface of the substrate 61.

The transistor 62 includes a gate insulating film 62a and a gate electrode 62b sequentially formed below the substrate 61. The gate insulating film 62a is, for example, a silicon oxide film. The gate electrode 62b is, for example, an N-type semiconductor layer (for example, a polysilicon layer). The transistor 62 constitutes, for example, a logic circuit of the solid-state imaging device of the present embodiment.

The interlayer insulating film 63 is formed under the substrate 61 and the transistor 62, and covers the transistor 62. The interlayer insulating film 63 is, for example, a multilayer insulating film including a silicon oxide film and another insulating film. In the present embodiment, the interlayer insulating film 63 is formed on an interlayer insulating film 24, and a lower surface of the interlayer insulating film 63 is in contact with an upper surface of the interlayer insulating film 24. The substrate 61 of the present embodiment is bonded to the substrate 21 via the interlayer insulating films 63 and 24.

As described above, the solid-state imaging device of the present embodiment has a three-layer structure including the substrate 11 (first layer), the substrate 21 (second layer), and the substrate 61 (third layer). A region in the substrate 11 and the interlayer insulating film 14 is referred to as a "first floor", a region in the substrate 21 and the interlayer insulating film 24 is referred to as a "second floor", and a region in the substrate 61 and the interlayer insulating film 63 is referred to as a "third floor". For example, the photodiode PD, a floating diffusion section FD, and the pixel transistors 12 and 13 are disposed on the first floor, a pixel transistor 23 is disposed on the second floor, and the transistor 62 is disposed on the third floor. Furthermore, the through plug 31 is disposed across the first floor and the second floor.

According to the present embodiment, by applying the three-layer structure to the solid-state imaging device, for example, the number of transistors disposed in the first layer or the second layer can be reduced. As a result, an area of each pixel 1 in plan view can be reduced, and a size (area) of the solid-state imaging device in plan view can be reduced.

Note that the structures of the first, second, and third floors of the present embodiment may be different from the structure illustrated in Fig. 28. For example, a part of the configuration elements of the first floor illustrated in Fig. 28 may be moved to the second floor or the third floor. The similarity applies to the configuration elements on the second floor illustrated in Fig. 28 and the configuration elements on the third floor illustrated in Fig. 28.

### (Application example)

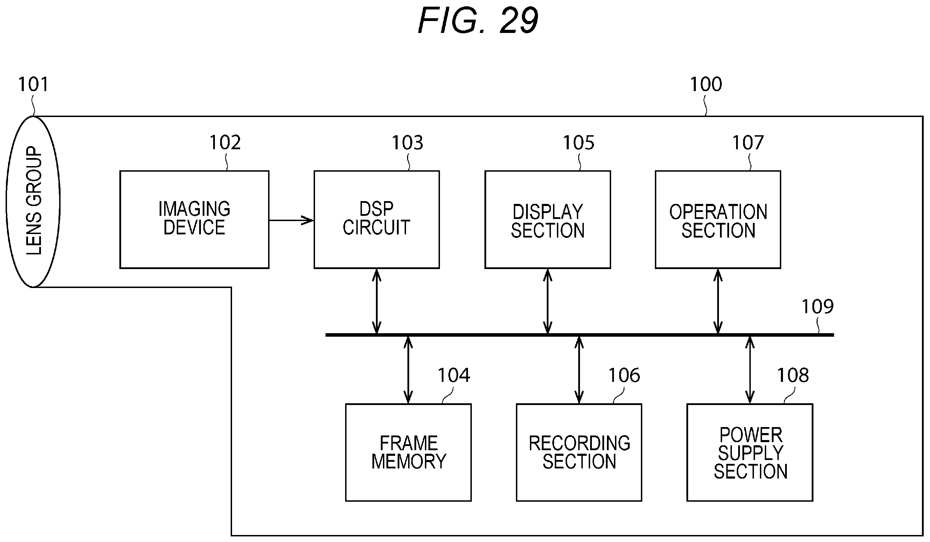

Fig. 29 is a block diagram illustrating a configuration example of an electronic device. The electronic device illustrated in Fig. 29 is a camera 100.

The camera 100 includes an optical section 101 including a lens group and the like, an imaging device 102 that is the solid-state imaging device according to any one of the first to fourteenth embodiments, a digital signal processor (DSP) circuit 103 that is a camera signal processing circuit, a frame memory 104, a display section 105, a recording section 106, an operation section 107, and a power supply section 108. Furthermore, the DSP circuit 103, the frame memory 104, the display section 105, the recording section 106, the operation section 107, and the power supply section 108 are connected to each other via a bus line 109.

The optical section 101 captures incident light (image light) from a subject and forms an image on an imaging surface of the imaging device 102. The imaging device 102 converts a light amount of incident light formed into an image on the imaging surface by the optical section 101 into an electric signal on a pixel-by-pixel basis and outputs the electric signal as a pixel signal.

The DSP circuit 103 performs signal processing on the pixel signal output from the imaging device 102. The frame memory 104 is a memory for storing one screen of a moving image or a still image captured by the imaging device 102.

The display section 105 includes, for example, a panel type display device such as a liquid crystal panel or an organic EL panel, and displays a moving image or a still image that is obtained by imaging by the imaging device 102. The recording section 106 records a moving image or a still image that is obtained by imaging by the imaging device 102 on a recording medium such as a hard disk or a semiconductor memory.

The operation section 107 issues operation commands for various functions of the camera 100 in response to an operation performed by a user. The power supply section 108 appropriately supplies various power supplies, which are operation power supplies for the DSP circuit 103, the frame memory 104, the display section 105, the recording section 106, and the operation section 107, to these power supply targets.

By using the solid-state imaging device according to any one of the first to fourteenth embodiments as the imaging device 102, acquisition of a good image can be expected.

The solid-state imaging device can be applied to various other products. For example, the solid-state imaging device may be mounted on any type of moving bodies such as vehicles, electric vehicles, hybrid electric vehicles, motorcycles, bicycles, personal mobility, airplanes, drones, ships, and robots.

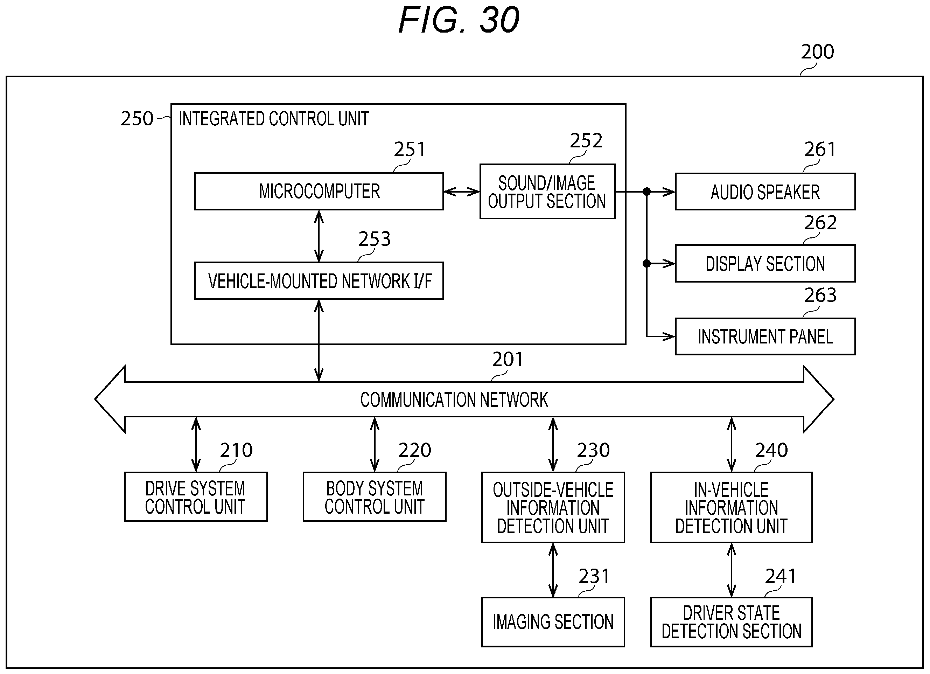

Fig. 30 is a block diagram illustrating a configuration example of a moving body control system. The moving body control system illustrated in Fig. 30 is a vehicle control system 200.

The vehicle control system 200 includes a plurality of electronic control units connected to each other via a communication network 201. In the example depicted in Fig. 30, the vehicle control system 200 includes a drive system control unit 210, a body system control unit 220, an outside-vehicle information detection unit 230, an in-vehicle information detection unit 240, and an integrated control unit 250. Fig. 30 further illustrates a microcomputer 251, a sound/image output section 252, and a vehicle-mounted network interface (I/F) 253 as components of the integrated control unit 250.

The drive system control unit 210 controls the operation of devices related to a driving system of a vehicle in accordance with various types of programs. For example, the drive system control unit 210 functions as a control device for a driving force generating device for generating a driving force of a vehicle, such as an internal combustion engine, a driving motor, or the like, a driving force transmitting mechanism for transmitting the driving force to wheels, a steering mechanism for adjusting a steering angle of the vehicle, a braking device for generating a braking force of the vehicle, and the like.

The body system control unit 220 controls the operation of various types of devices provided to a vehicle body in accordance with various types of programs. For example, the body system control unit 220 functions as a control device for a smart key system, a keyless entry system, a power window device, or various types of lamps (for example, a head lamp, a backup lamp, a brake lamp, a turn signal, a fog lamp, or the like). In this case, radio waves transmitted from a mobile device as an alternative to a key or signals of various types of switches can be input to the body system control unit 220. The body system control unit 220 receives inputs of such radio waves or signals, and controls a door lock device, the power window device, the lamps, or the like of the vehicle.

The outside-vehicle information detection unit 230 detects information of the outside of the vehicle including the vehicle control system 200. The outside-vehicle information detection unit 230 is connected with, for example, an imaging section 231. The outside-vehicle information detection unit 230 makes the imaging section 231 capture an image of the outside of the vehicle, and receives the captured image from the imaging section 231. On the basis of the received image, the outside-vehicle information detection unit 230 may perform processing of detecting an object such as a human, an automobile, an obstacle, a sign, a character on a road surface, or the like, or processing of detecting a distance thereto.

The imaging section 231 is an optical sensor that receives light and that outputs an electric signal corresponding to the amount of received light. The imaging section 231 can output the electric signal as an image, or can output the electric signal as information on a measured distance. The light received by the imaging section 231 may be visible light, or may be invisible light such as infrared rays or the like. The imaging section 231 includes the solid-state imaging device according to any one of the first to fourteenth embodiments.

The in-vehicle information detection unit 240 detects information of the inside of the vehicle including the vehicle control system 200. The in-vehicle information detection unit 240 is, for example, connected with a driver state detection section 241 that detects a state of a driver. For example, the driver state detection section 241 includes a camera that captures an image of the driver, and on the basis of detection information input from the driver state detection section 241, the in-vehicle information detection unit 240 may calculate a degree of fatigue of the driver or a degree of concentration of the driver, or may determine whether or not the driver is dozing off. The camera may include the solid-state imaging device according to any one of the first to fourteenth embodiments, and may be, for example, the camera 100 illustrated in Fig. 29.

The microcomputer 251 can calculate a control target value for the driving force generating device, the steering mechanism, or the braking device on the basis of the information of the inside or outside of the vehicle obtained by the outside-vehicle information detection unit 230 or the in-vehicle information detection unit 240, and output a control command to the drive system control unit 210. For example, the microcomputer 251 can perform cooperative control intended to implement functions of an advanced driver assistance system (ADAS), the functions including collision avoidance or shock mitigation for the vehicle, following traveling based on a following distance, vehicle speed maintaining traveling, a warning of collision of the vehicle, a warning of deviation of the vehicle from a lane, and the like.

Furthermore, the microcomputer 251 can perform cooperative control intended for automated driving or the like in which the vehicle travels autonomously without depending on the operation of the driver by controlling the driving force generating device, the steering mechanism, or the braking device on the basis of the information of the surroundings of the vehicle obtained by the outside-vehicle information detection unit 230 or the in-vehicle information detection unit 240.

Furthermore, the microcomputer 251 can output a control command to the body system control unit 220 on the basis of the information of the outside of the vehicle obtained by the outside-vehicle information detection unit 230. For example, the microcomputer 251 can perform cooperative control for the purpose of preventing glare, such as switching from a high beam to a low beam, by controlling the headlamp according to the position of a preceding vehicle or an oncoming vehicle detected by the outside-vehicle information detection unit 230.

The sound/image output section 252 transmits an output signal of at least one of a sound or an image to an output device that can visually or auditorily provide information to an occupant of the vehicle or the outside of the vehicle. In the example of Fig. 30, an audio speaker 261, a display section 262, and an instrument panel 263 are illustrated as the output device described above. The display section 262 may, for example, include an on-board display or a head-up display.

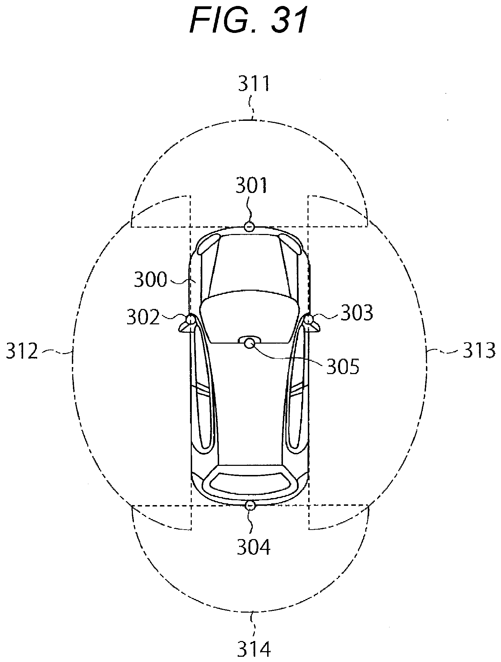

Fig. 31 is a plan view illustrating a specific example of a setting position of the imaging section 231 in Fig. 30.

A vehicle 300 illustrated in Fig. 31 includes imaging sections 301, 302, 303, 304, and 305 as the imaging section 231. The imaging sections 301, 302, 303, 304, and 305 are, for example, provided at positions on a front nose, side mirrors, a rear bumper, and a back door of the vehicle 300, and on an upper portion of a windshield in the interior of the vehicle.

The imaging section 301 provided on the front nose mainly acquires an image of the front of the vehicle 300. The imaging section 302 provided on the left side mirror and the imaging section 303 provided on the right side mirror mainly acquire images of the sides of the vehicle 300. The imaging section 304 provided to the rear bumper or the back door mainly acquires an image of the rear of the vehicle 300. The imaging section 305 provided to the upper portion of the windshield in the interior of the vehicle mainly acquires an image of the front of the vehicle 300. The imaging section 305 is used to detect, for example, a preceding vehicle, a pedestrian, an obstacle, a traffic light, a traffic sign, a lane, and the like.

Fig. 31 illustrates an example of imaging ranges of the imaging sections 301, 302, 303, and 304 (hereinafter referred to as "imaging sections 301 to 304"). An imaging range 311 represents the imaging range of the imaging section 301 provided to the front nose. An imaging range 312 represents the imaging range of the imaging section 302 provided to the left side mirror. An imaging range 313 represents the imaging range of the imaging section 303 provided to the right side mirror. An imaging range 314 represents the imaging range of the imaging section 304 provided to the rear bumper or the back door. For example, an overhead view of the vehicle 300 as viewed from above is obtained by superimposing image data captured by the imaging sections 301 to 304. Hereinafter, the imaging ranges 311, 312, 313, and 314 are referred to as the "imaging ranges 311 to 314".

At least one of the imaging sections 301 to 304 may have a function of acquiring distance information. For example, at least one of the imaging sections 301 to 304 may be a stereo camera including a plurality of imaging devices or an imaging device including pixels for phase difference detection.

For example, the microcomputer 251 (Fig. 30) can determine a distance to each three-dimensional object within the imaging ranges 311 to 314 and a temporal change in the distance (relative speed with respect to the vehicle 300) on the basis of the distance information obtained from the imaging sections 301 to 304. On the basis of the calculation results, the microcomputer 251 can extract, as a preceding vehicle, a nearest three-dimensional object that is present on a traveling path of the vehicle 300 and travels in substantially the same direction as the vehicle 300 at a predetermined speed (for example, equal to or more than 0 km/h). Moreover, the microcomputer 251 can set a following distance to be maintained in front of a preceding vehicle in advance, and perform automatic brake control (including following stop control), automatic acceleration control (including following start control), or the like. According to this example, the cooperative control intended for automated driving that makes the vehicle travel autonomously and the like can be performed without depending on the operation of the driver.

For example, the microcomputer 251 can classify three-dimensional object data related to three-dimensional objects into a two-wheeled vehicle, a standard-sized vehicle, a large-sized vehicle, a pedestrian, a utility pole, and other three-dimensional objects on the basis of the distance information obtained from the imaging sections 301 to 304, extract the classified three-dimensional object data, and use the extracted three-dimensional object data for automatic avoidance of an obstacle. For example, the microcomputer 251 identifies obstacles around the vehicle 300 as obstacles that the driver of the vehicle 300 can recognize visually and obstacles that are difficult for the driver of the vehicle 300 to recognize visually. Then, the microcomputer 251 determines a collision risk indicating a risk of collision with each obstacle, and in a situation in which the collision risk is equal to or higher than a set value and there is thus a possibility of collision, the microcomputer 251 outputs a warning to the driver via the audio speaker 261 or the display section 262, and performs forced deceleration or avoidance steering via the drive system control unit 210 to assist in driving to avoid collision.

At least one of the imaging sections 301 to 304 may be an infrared camera that detects infrared light. The microcomputer 251 can, for example, recognize a pedestrian by determining whether or not there is a pedestrian in images captured by the imaging sections 301 to 304. Such recognition of a pedestrian is, for example, performed by a procedure of extracting characteristic points in the images captured by the imaging sections 301 to 304 as infrared cameras and a procedure of determining whether or not an object is a pedestrian by performing pattern matching processing on a series of characteristic points representing the contour of the object. In a case where the microcomputer 251 determines that there is a pedestrian in the captured images captured by the imaging sections 301 to 304 and recognizes the pedestrian, the sound/image output section 252 controls the display section 262 so that a square contour line for emphasis is displayed in a superimposed manner on the recognized pedestrian. Furthermore, the sound/image output section 252 may also control the display section 262 so that an icon or the like representing the pedestrian is displayed at a desired position.

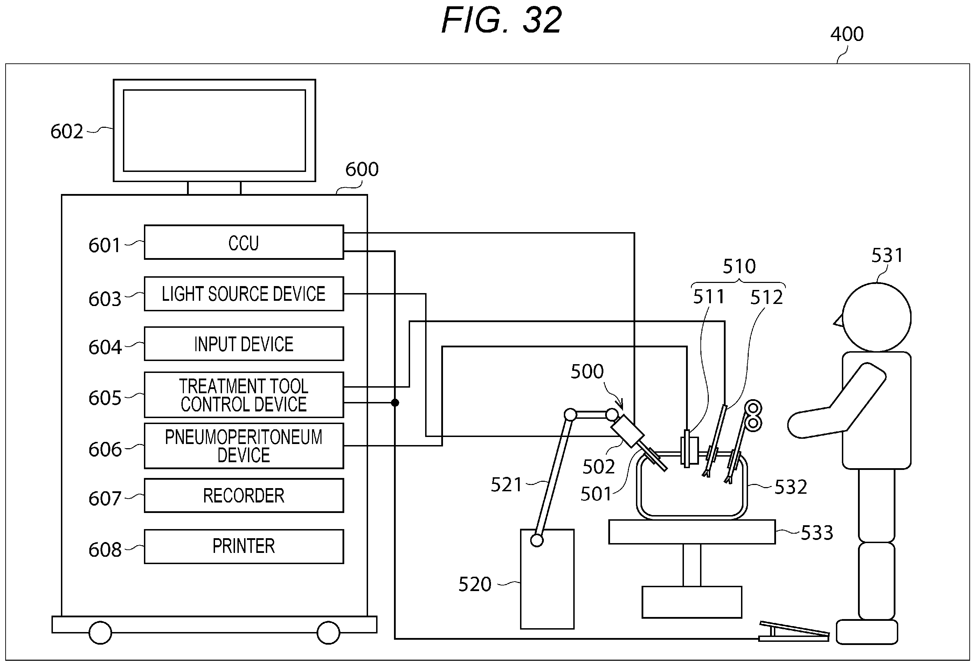

Fig. 32 is a diagram illustrating an example of a schematic configuration of an endoscopic surgical system to which the technology (present technology) according to the present disclosure can be applied.

Fig. 32 illustrates a state in which an operator (surgeon) 531 performs surgery on a patient 532 on a patient bed 533 using an endoscopic surgical system 400. As illustrated, the endoscopic surgical system 400 includes an endoscope 500, other surgical tools 510 such as a pneumoperitoneum tube 511 and an energy treatment tool 512, a supporting arm device 520 for supporting the endoscope 500, and a cart 600 on which various devices for endoscopic surgery are mounted.

The endoscope 500 includes a lens barrel 501 including a region of a predetermined length from a distal end thereof to be inserted into a body cavity of the patient 532, and a camera head 502 connected to a proximal end of the lens barrel 501. Although the illustrated example illustrates the endoscope 500 is configured as a so-called rigid endoscope having a rigid lens barrel 501, the endoscope 500 may be a so-called flexible endoscope having a flexible lens barrel.

An opening in which an objective lens is fitted is provided at the distal end of the lens barrel 501. A light source device 603 is connected to the endoscope 500, and light generated by the light source device 603 is guided to the distal end of the lens barrel by a light guide extending in the lens barrel 501 and is emitted to an observation target in the body cavity of the patient 532 through the objective lens. Note that the endoscope 500 may be a forward-viewing endoscope, an oblique-viewing endoscope, or a side-viewing endoscope.

An optical system and an imaging element are provided in the camera head 502, and light reflected by the observation target (observation light) is collected on the imaging element by the optical system. The observation light is photoelectrically converted by the imaging element to generate an electric signal corresponding to the observation light, namely, an image signal corresponding to an observation image. The image signal is transmitted to a camera control unit (CCU) 601 as RAW data.

The CCU 601 includes a central processing unit (CPU), a graphics processing unit (GPU), and the like, and integrally controls the operations of the endoscope 500 and a display device 602. Moreover, the CCU 601 receives the image signal from the camera head 502 and applies, on the image signal, various types of image processing, for example, development processing (demosaicing processing) or the like for displaying an image based on the image signal.

The display device 602 displays the image based on the image signal which has been subjected to the image processing by the CCU 601 under the control of the CCU 601.

The light source device 603 includes, for example, a light source such as a light emitting diode (LED), and supplies irradiation light for capturing an image of a surgical site or the like to the endoscope 500.

An input device 604 is an input interface for the endoscopic surgical system 11000. A user may input various types of information and instructions to the endoscopic surgical system 400 via the input device 604. For example, the user inputs an instruction and the like to change an imaging condition (type of irradiation light, magnification, focal length and the like) by the endoscope 500.

A treatment tool control device 605 controls driving of the energy treatment tool 512 for tissue cauterization, incision, blood vessel sealing, and the like. A pneumoperitoneum device 606 sends gas into the body cavity of the patient 532 via the pneumoperitoneum tube 511 in order to inflate the body cavity for a purpose of securing a field of view by the endoscope 500 and securing work space for the operator. A recorder 607 is a device that can record various types of information regarding surgery. A printer 608 is a device that can print various types of information regarding surgery in various formats such as a text, an image, or a graph.

Note that the light source device 603 which supplies the irradiation light for imaging the surgical site to the endoscope 500 may include, for example, an LED, a laser light source, or a white light source obtained by combining these. In a case where the white light source includes a combination of RGB laser light sources, because an output intensity and an output timing of each color (each wavelength) can be controlled with high accuracy, the light source device 603 can adjust white balance of a captured image. Furthermore, in this case, by irradiating the observation target with the laser light from each of the R, G, and B laser light sources in time division and controlling driving of the imaging element of the camera head 502 in synchronism with the irradiation timing, images corresponding to R, G, and B can be captured in time division. According to this method, a color image can be obtained even if color filters are not provided for the imaging element.

Furthermore, the driving of the light source device 603 may be controlled so that the intensity of light to be output is changed every predetermined time. By controlling driving of the imaging element of the camera head 502 in synchronism with the timing of the change of the intensity of light to acquire images time-divisionally and synthesizing the images, an image of a high dynamic range free from underexposed blocked up shadows and overexposed highlights can be created.

Furthermore, the light source device 603 may be able to supply light in a predetermined wavelength band adapted to special light observation. In special light observation, for example, by utilizing the wavelength dependency of absorption of light in a body tissue to irradiate light of a narrow band in comparison with irradiation light upon ordinary observation (namely, white light), narrow band observation (narrow band imaging) of imaging a predetermined tissue such as a blood vessel of a superficial portion of the mucous membrane or the like in a high contrast is performed. Alternatively, in special light observation, fluorescent observation for obtaining an image from fluorescent light generated by irradiation of excitation light may be performed. In fluorescent observation, it is possible to perform observation of fluorescent light from a body tissue by irradiating excitation light on the body tissue (autofluorescence observation) or to obtain a fluorescent light image by locally injecting a reagent such as indocyanine green (ICG) into a body tissue and irradiating excitation light corresponding to a fluorescent light wavelength of the reagent upon the body tissue. The light source device 603 can be configured to supply narrow band light and/or excitation light adapted to such special light observation.

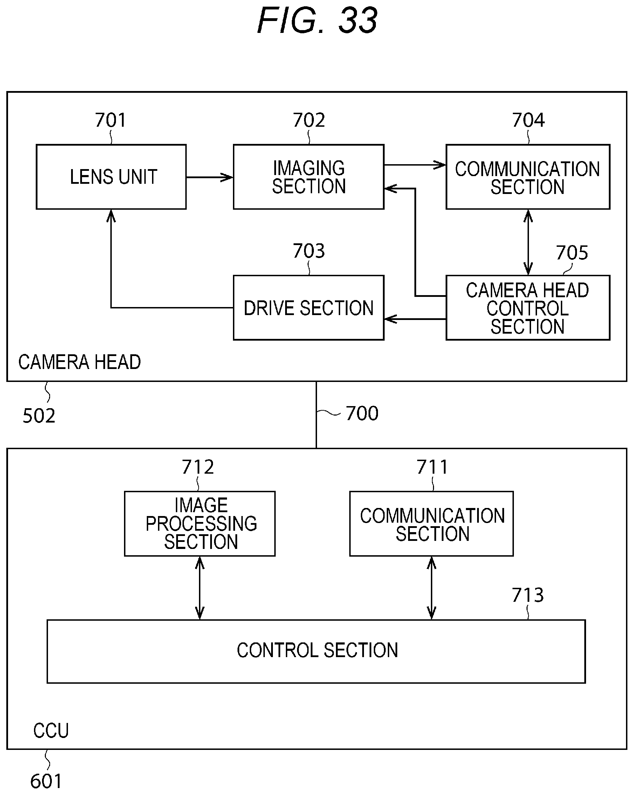

Fig. 33 is a block diagram illustrating an example of functional configurations of the camera head 502 and the CCU 601 depicted in Fig. 32.

The camera head 502 includes a lens unit 701, an imaging section 702, a drive section 703, a communication section 704, and a camera head control section 705. The CCU 601 includes a communication section 711, an image processing section 712, and a control section 713. The camera head 502 and the CCU 601 are connected to each other communicably by a transmission cable 700.

The lens unit 701 is an optical system provided at a connection portion with the lens barrel 501. The observation light captured from the distal end of the lens barrel 501 is guided to the camera head 502 and enters the lens unit 701. The lens unit 701 is configured by combining a plurality of lenses including a zoom lens and a focus lens.

The imaging section 702 includes an imaging element. The number of imaging elements included in the imaging section 702 may be one (so-called single plate type) or two or more (so-called multiple plate type). In a case where the imaging section 702 is configured as the multiple plate type, for example, image signals corresponding to R, G, and B may be generated by the respective imaging elements, and a color image may be obtained by combining the generated image signals. Alternatively, the imaging section 702 may include a pair of imaging elements for obtaining right-eye and left-eye image signals corresponding to three-dimensional (3D) display. By performing the 3D display, the surgeon 531 can grasp a depth of a living body tissue in a surgical site more accurately. Note that, in a case where the imaging section 702 is configured as the multiple plate type, a plurality of systems of the lens units 701 may be provided so as to correspond to the respective imaging elements. The imaging section 702 is, for example, the solid-state imaging device according to any one of the first to 14 embodiments.

Furthermore, the imaging section 702 is not necessarily provided in the camera head 502. For example, the imaging section 702 may be provided inside the lens barrel 501 immediately behind the objective lens.

The drive section 703 includes an actuator and moves the zoom lens and the focusing lens of the lens unit 701 by a predetermined distance along an optical axis under the control of the camera head control section 705. With this arrangement, the magnification and focal point of the image captured by the imaging section 702 may be appropriately adjusted.

The communication section 704 includes a communication device for transmitting and receiving various types of information to and from the CCU 601. The communication section 704 transmits the image signal obtained from the imaging section 702 as the RAW data to the CCU 601 via the transmission cable 700.

Furthermore, the communication section 704 receives a control signal for controlling driving of the camera head 502 from the CCU 601 and supplies the control signal to the camera head control section 705. The control signal includes information relating to imaging conditions such as, for example, information that a frame rate of a captured image is designated, information that an exposure value upon image picking up is designated and/or information that a magnification and a focal point of a captured image are designated.

Note that the imaging conditions such as the frame rate, exposure value, magnification, and focus described above may be appropriately specified by the user, or may be automatically set by the control section 713 of the CCU 601 on the basis of the acquired image signal. In the latter case, the endoscope 500 is equipped with a so-called auto exposure (AE) function, an auto focus (AF) function, and an auto white balance (AWB) function.

The camera head control section 705 controls the driving of the camera head 502 on the basis of the control signal from the CCU 601 received via the communication section 704.

The communication section 711 includes a communication device for transmitting and receiving various types of information to and from the camera head 502. The communication section 711 receives the image signal transmitted from the camera head 502 via the transmission cable 700.

Furthermore, the communication section 711 transmits the control signal for controlling the driving of the camera head 502 to the camera head 502. The image signal and the control signal can be transmitted by electrical communication, optical communication or the like.

The image processing section 712 performs various types of image processing on the image signal which is the RAW data transmitted from the camera head 502.

The control section 713 performs various types of control regarding imaging of the surgical site and the like by the endoscope 500 and display of the captured image obtained by the imaging of the surgical site and the like. For example, the control section 713 generates the control signal for controlling the driving of the camera head 502.

Furthermore, the control section 713 allows the display device 602 to display the captured image including the surgical site and the like on the basis of the image signal subjected to the image processing by the image processing section 712. At this time, the control section 713 may recognize various objects in the captured image using various image recognition technologies. For example, the control section 713 may detect edge shapes, colors, and the like of the objects included in the captured image, to recognize the surgical tool such as forceps, a specific living body site, bleeding, mist when the energy treatment tool 512 is used, and the like. At the time of causing the display device 602 to display the captured image, the control section 713 may overlay various types of surgery assistance information on the image of the surgical site using the recognition result. The surgery assistance information is displayed to be overlaid and presented to the surgeon 531, which can reduce the burden on the surgeon 531 and enable the surgeon 531 to reliably proceed with surgery.

The transmission cable 700 connecting the camera head 502 and the CCU 601 is an electric signal cable compatible with communication of electric signals, an optical fiber compatible with optical communication, or a composite cable thereof.

Here, in the illustrated example, the communication is performed wired using the transmission cable 700, but the communication between the camera head 502 and the CCU 601 may be performed wirelessly.

Although the embodiments of the present disclosure have been described above, these embodiments may be implemented with various modifications within a scope not departing from the gist of the present disclosure. For example, two or more embodiments may be implemented in combination.

Note that the present disclosure can also have the following configurations.

(1) A solid-state imaging device including:
   a first substrate;
   a first transistor provided on the first substrate;
   a first insulating film provided on the first substrate and the first transistor;
   a first wiring provided in the first insulating film and electrically connected to the first substrate or the first transistor;
   a second substrate provided on the first insulating film; and
   a first plug provided in the first insulating film and the second substrate and provided on the first wiring to be electrically connected to the first wiring.
(2) The solid-state imaging device according to (1), further including a photoelectric conversion section and a floating diffusion section provided in the first substrate.
(3) The solid-state imaging device according to (1), in which the first transistor includes a transfer transistor, an amplification transistor, a switch transistor, or a reset transistor.
(4) The solid-state imaging device according to (1), in which the first wiring includes a semiconductor layer.
(5) The solid-state imaging device according to (4), in which the semiconductor layer includes a P-type semiconductor layer or an N-type semiconductor layer.
(6) The solid-state imaging device according to (1), in which the first plug includes a metal layer.
(7) The solid-state imaging device according to (1), further including:
   a second transistor provided on the second substrate; and
   a second insulating film provided on the second substrate and the second transistor.
(8) The solid-state imaging device according to (7), in which the second transistor includes a selection transistor.
(9) The solid-state imaging device according to (7), in which the first plug is provided in the first insulating film, the second substrate, and the second insulating film.
(10) The solid-state imaging device according to (7), in which the second transistor includes an amplification transistor, a switch transistor, or a reset transistor.
(11) The solid-state imaging device according to (1), in which the first plug is electrically connected to a floating diffusion section provided in the first substrate via the first wiring.
(12) The solid-state imaging device according to (1), further including: a second plug provided in the first insulating film and the second substrate and provided on the first substrate to be electrically connected to the first substrate.
(13) The solid-state imaging device according to (12), in which the second plug is provided on a diffusion region provided in the first substrate.
(14) The solid-state imaging device according to (12), in which the second plug includes a metal layer.
(15) The solid-state imaging device according to (1), further including
   a lens provided on a second surface side of the first substrate,
   in which the first transistor is provided on a first surface side of the first substrate.
(16) The solid-state imaging device according to (7), further including:
   a third substrate provided above the second substrate;
   a third transistor provided below the third substrate; and
   a third insulating film provided below the third substrate and the third insulating film and provided on the second insulating film.
(17) A manufacturing method of a solid-state imaging device, the manufacturing method including:
   forming a first transistor on a first substrate;
   forming a first portion of a first insulating film on the first substrate and the first transistor;
   forming a first wiring on the first portion of the first insulating film to be electrically connected to the first substrate or the first transistor;
   forming a second portion of the first insulating film on the first portion of the first insulating film and the first wiring;
   disposing a second substrate on the first insulating film; and
   forming a first plug provided on the first wiring and electrically connected to the first wiring in the first insulating film and the second substrate.
(18) The manufacturing method of the solid-state imaging device according to (17), in which the first wiring is formed to include a semiconductor layer.
(19) The manufacturing method of a solid-state imaging device according to (18), further including implanting a P-type impurity or an N-type impurity into the semiconductor layer.
(20) The manufacturing method of a solid-state imaging device according to (17), in which the first plug is formed to include a metal layer.

### REFERENCE SIGNS LIST

- 1: Pixel
- 2: Pixel array region
- 3: Control circuit
- 4: Vertical drive circuit
- 5: Column signal processing circuit
- 6: Horizontal drive circuit
- 7: Output circuit
- 8: Vertical signal line
- 9: Horizontal signal line
- 11: Substrate
- 11a: Well region
- 11b: Diffusion region
- 11c: Diffusion region
- 11d: Diffusion region
- 12: Pixel transistor
- 12a: Gate insulating film
- 12b: Gate electrode
- 12c: Sidewall insulating film
- 13: Pixel transistor
- 13a: Gate insulating film
- 13b: Gate electrode
- 13c: Sidewall insulating film
- 14: Interlayer insulating film
- 14a: Insulating film
- 14b: Insulating film
- 14c: Insulating film
- 14d: Insulating film
- 15: Contact plug
- 15a: Plug
- 15b: Plug
- 15c: Plug
- 15d: Plug
- 15e: Plug
- 16: Wiring layer
- 16a: Wiring
- 16b: Wiring
- 16c: Wiring
- 21: Substrate
- 22: Insulating film
- 23: Pixel transistor
- 23a: Gate insulating film
- 23b: Gate electrode
- 24: Interlayer insulating film
- 25: Contact plug
- 25a: Plug
- 25b: Plug
- 25c: Plug
- 31: Through plug
- 31a: Plug
- 31b: Plug
- 31c: Plug
- 41: Element isolation insulating film
- 42: Semiconductor layer
- 42a: N-type region
- 42b: P-type region
- 42c: N-type region
- 42d: N-type region
- 43: Mask layer
- 51: On-chip filter
- 52: On-chip lens
- 61: Substrate
- 62: Transistor
- 62a: Gate insulating film
- 62b: Gate electrode
- 63: Interlayer insulating film

## Claims

1. A solid-state imaging device comprising:
a first substrate;
a first transistor provided on the first substrate;
a first insulating film provided on the first substrate and the first transistor;
a first wiring provided in the first insulating film and electrically connected to the first substrate or the first transistor;
a second substrate provided on the first insulating film; and
a first plug provided in the first insulating film and the second substrate and provided on the first wiring to be electrically connected to the first wiring.

2. The solid-state imaging device according to claim 1, further comprising a photoelectric conversion section and a floating diffusion section provided in the first substrate.

3. The solid-state imaging device according to claim 1, wherein the first transistor includes a transfer transistor, an amplification transistor, a switch transistor, or a reset transistor.

4. The solid-state imaging device according to claim 1, wherein the first wiring includes a semiconductor layer.

5. The solid-state imaging device according to claim 4, wherein the semiconductor layer includes a P-type semiconductor layer or an N-type semiconductor layer.

6. The solid-state imaging device according to claim 1, wherein the first plug includes a metal layer.

7. The solid-state imaging device according to claim 1, further comprising:
a second transistor provided on the second substrate; and
a second insulating film provided on the second substrate and the second transistor.

8. The solid-state imaging device according to claim 7, wherein the second transistor includes a selection transistor.

9. The solid-state imaging device according to claim 7, wherein the first plug is provided in the first insulating film, the second substrate, and the second insulating film.

10. The solid-state imaging device according to claim 7, wherein the second transistor includes an amplification transistor, a switch transistor, or a reset transistor.

11. The solid-state imaging device according to claim 1, wherein the first plug is electrically connected to a floating diffusion section provided in the first substrate via the first wiring.

12. The solid-state imaging device according to claim 1, further comprising a second plug provided in the first insulating film and the second substrate and provided on the first substrate to be electrically connected to the first substrate.

13. The solid-state imaging device according to claim 12, wherein the second plug is provided on a diffusion region provided in the first substrate.

14. The solid-state imaging device according to claim 12, wherein the second plug includes a metal layer.

15. The solid-state imaging device according to claim 1, further comprising
a lens provided on a second surface side of the first substrate,
wherein the first transistor is provided on a first surface side of the first substrate.

16. The solid-state imaging device according to claim 7, further comprising:
a third substrate provided above the second substrate;
a third transistor provided below the third substrate; and
a third insulating film provided below the third substrate and the third insulating film and provided on the second insulating film.

17. A manufacturing method of a solid-state imaging device, the manufacturing method comprising:
forming a first transistor on a first substrate;
forming a first portion of a first insulating film on the first substrate and the first transistor;
forming a first wiring on the first portion of the first insulating film to be electrically connected to the first substrate or the first transistor;
forming a second portion of the first insulating film on the first portion of the first insulating film and the first wiring;
disposing a second substrate on the first insulating film; and
forming a first plug provided on the first wiring and electrically connected to the first wiring in the first insulating film and the second substrate.

18. The manufacturing method of a solid-state imaging device according to claim 17, wherein the first wiring is formed to include a semiconductor layer.

19. The manufacturing method of a solid-state imaging device according to claim 18, further comprising implanting a P-type impurity or an N-type impurity into the semiconductor layer.

20. The manufacturing method of a solid-state imaging device according to claim 17, wherein the first plug is formed to include a metal layer.
